(19) Europäisches Patentamt
European Patent Office
Office européen des brevets

(11) EP 2 644 654 A1

(12) **EUROPEAN PATENT APPLICATION**
published in accordance with Art. 153(4) EPC

(43) Date of publication:
**02.10.2013 Bulletin 2013/40**

(21) Application number: **11843275.6**

(22) Date of filing: **22.11.2011**

(51) Int Cl.:
***C08L 71/10*** *(2006.01)* ***H01L 21/312*** *(2006.01)*

(86) International application number:
**PCT/JP2011/076958**

(87) International publication number:
**WO 2012/070590 (31.05.2012 Gazette 2012/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.11.2010 JP 2010261230**
**27.01.2011 JP 2011015346**

(71) Applicant: **JSR Corporation**
**Minato-ku**
**Tokyo 105-8640 (JP)**

(72) Inventors:
- **OKANIWA, Motoki**
  **Tokyo 105-8640 (JP)**
- **UNO, Takaaki**
  **Tokyo 105-8640 (JP)**
- **OKADA, Takashi**
  **Tokyo 105-8640 (JP)**

(74) Representative: **TBK**
**Bavariaring 4-6**
**80336 München (DE)**

# (54) RESIN COMPOSITION, INSULATING FILM, FILM FORMING METHOD, AND ELECTRONIC COMPONENT

(57) A resin composition containing: a polymer having at least one structural unit (i) selected from a group consisting of a structural unit represented by formula (1) and a structural unit represented by formula (2); and at least one organic solvent selected from a group consisting of ether solvents, ketone solvents, ester solvents and amide solvents.

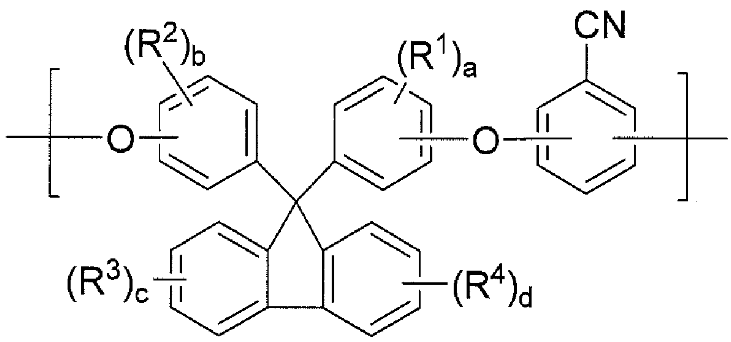

(1)

EP 2 644 654 A1

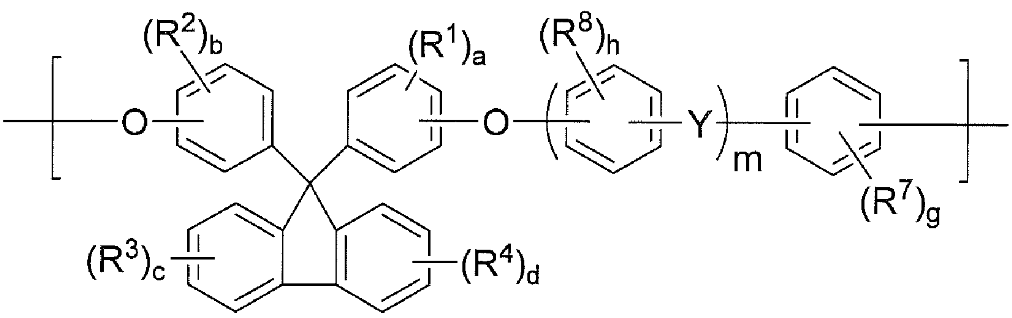

(2)

Fig.1

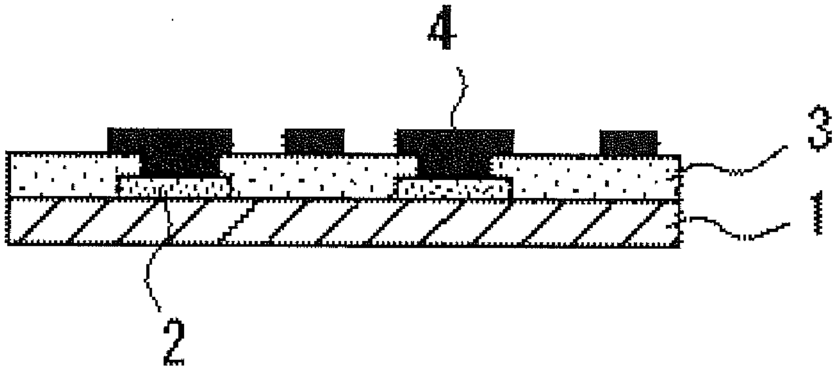

## Description

### TECHNICAL FIELD

The present invention relates to a resin composition, an insulating film, a process for forming a film, and an electronic part.

### BACKGROUND ART

With recent remarkable development of information technologies bringing about the trend for information devices that are lighter, thinner and smaller, transparent resins have been used as optical materials in various applications. Typical examples of the transparent resins include PMMA and polycarbonate. The PMMA and polycarbonate, though excellent in transparency, have low glass transition temperature and insufficient heat resistance, and thus are difficult to use in applications requiring high heat resistance. Furthermore, the applications of engineering plastics have widened according to technology advancement, and polymers excellent in heat resistance, mechanical strength, transparency are demanded.

As polymers excellent in heat resistance, mechanical strength and transparency, aromatic polyethers obtained by reacting 9, 9- bis (4- hydroxyphenyl) fluorine, various bisphenols and 2, 6- dihalogenated benzonitrile are proposed (Patent Literatures 1 and 2) .

### CITATION LIST

### PATENT LITERATURES

Patent Literature 1: JP- A- 2007- 246629
Patent Literature 2: JP- A- H02- 45526

### SUMMARY OF INVENTION

### TECHNICAL PROBLEM

However, resin compositions containing these aromatic polyethers have poor wettability (cissing) to substrates when forming films, causing turbidity and roughness in the films obtained in some cases. In the above Patent Literatures, halogenated hydrocarbons are used as solvents for film formation, resulting in greater environmental load and poor quality of the films formed in some cases due to degradation of the solvents during the film formation.

The present invention has been made in view of the above problems. It is an object of the present invention to provide a resin composition capable of forming a film having excellent wettability to a substrate and being less prone to turbidity and roughness, as well as to provide a process for forming a film using the composition. It is an another object of the present invention to provide increased safety to human body by using a non-halogenated solvent, while reducing the deterioration of the film quality due to degradation of the solvent during the film formation.

### TECHNICAL SOLUTION

As a result of diligent research to solve the problems described above, the present inventors discovered that the problems could be solved by using a resin composition comprising a specific aromatic polyether-based resin (I) and a specific solvent (II), thereby completing the invention. That is, the present invention provides the following [1] to [15].

[1] A resin composition comprising a polymer that comprises at least one structural unit (i) selected from the group consisting of structural units represented by the following formula (1) and structural units represented by the following formula (2); and at least one kind of organic solvent selected from the group consisting of ether solvents, ketone solvents, ester solvents and amide solvents.

[Chem. 1]

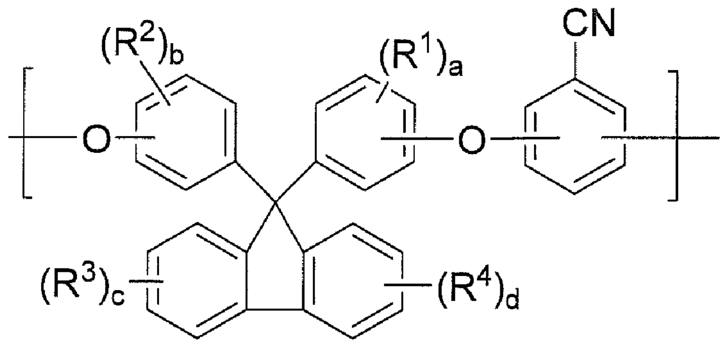

(1)

In the formula (1), $R^1$ to $R^4$ are each independently a monovalent organic group having 1 to 12 carbon atoms; and "a" to "d" are each independently an integer of from 0 to 4.

[Chem. 2]

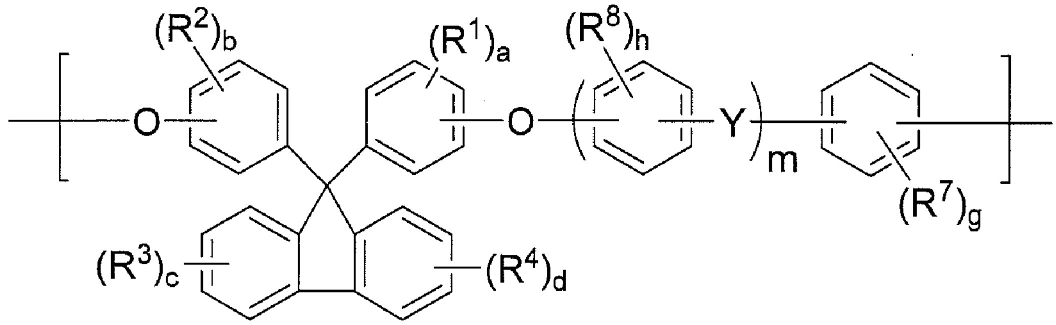

(2)

In the formula (2), $R^1$ to $R^4$ and "a" to "d" are each independently defined in the same manner as described for $R^1$ to $R^4$ and "a" to "d" of the formula (1); Y is a single bond, $-SO_2$-or >C=O; $R^7$ and $R^8$ are each independently a halogen atom, a monovalent organic group having 1 to 12 carbon atoms or a nitro group; "g" and "h" are each independently an integer of from 0 to 4; and "m" is 0 or 1, provided that when m is 0, $R^7$ is not a cyano group.

[2] A resin composition as described in [1], wherein the organic solvent comprises at least one kind of organic solvent selected from the group consisting of ketone solvents, ester solvents and ether solvents; and an amide solvent.

[3] A resin composition as described in [1] or [2], wherein the ketone solvents are ketones having not less than 4 and not more than 10 carbon atoms.

[4] A resin composition as described in any one of [1] to [3], wherein the ester solvents are esters having not less than 3 and not more than 10 carbon atoms.

[5] A resin composition as described in any one of [1] to [4], wherein the ether solvents are ethers having not less than 3 and not more than 10 carbon atoms.

[6] A resin composition as described in any one of [1] to [5], wherein the amide solvents are amides having not less than 3 and not more than 10 carbon atoms.

[7] A resin composition as described in any one of [1] to [6], wherein the organic solvent comprises 5 to 95 parts by mass of the amide solvent based on 100 parts by mass of the total organic solvents.

[8] A resin composition as described in any one of [1] to [7], wherein the polymer concentration in the resin composition is 3 to 40% by mass.

[9] A resin composition as described in any one of [1] to [8], wherein the polymer further comprises at least one structural unit (ii) selected from the group consisting of structural units represented by the following formula (3) and structural units represented by the following formula (4).

[Chem. 3]

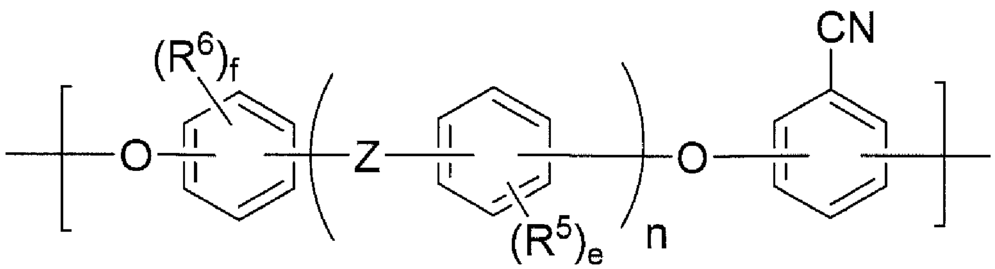

(3)

In the formula (3), $R^5$ and $R^6$ are each independently a monovalent organic group having 1 to 12 carbon atoms; Z is a single bond, -O-, -S-, $-SO_2-$, >C=O, -CONH-, -COO- or a divalent organic group having 1 to 12 carbon atoms; "e" and "f" are each independently an integer of from 0 to 4; and "n" is 0 or 1.

[Chem. 4]

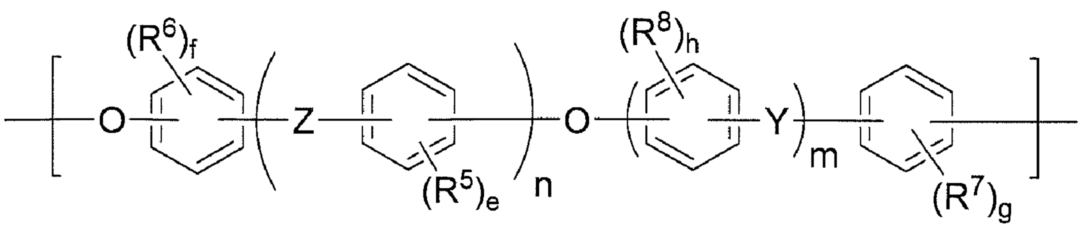

(4)

In the formula (4), $R^7$, $R^8$, Y, "m", "g" and "h" are each independently defined in the same manner as described for $R^7$, $R^8$, Y, "m", "g" and "h" of the formula (2), and $R^5$, $R^6$, Z, "n", "e" and "f" are each independently defined in the same manner as described for $R^5$, $R^6$, Z, "n" "e" and "f" of the formula (3).

[10] A resin composition as described in [9], wherein the molar ratio of the structural unit (i) to the structural unit (ii) in the polymer is 50:50 to 100:0.

[11] A resin composition as described in any one of [1] to [10], wherein the polymer has a weight average molecular weight in terms of polystyrene measured by gel permeation chromatography (GPC) of 5,000 to 500,000.

[12] A resin composition as described in any one of [1] to [11], which is used for at least one use selected from the

group consisting of use for forming an insulating film, use for a semiconductor element, use for a display element and use for forming a protective film.

[13] An insulating film obtained from the resin composition as described in any one of [1] to [11].

[14] A process for forming a film, comprising the steps of applying the resin composition as described in any one of [1] to [12] on a substrate to form a coating film, and removing the organic solvent from the coating film to provide a film.

[15] An electronic part comprising the insulating film as described in [13], or the film obtained by the process for forming a film as described in [14].

## ADVANTAGEOUS EFFECTS OF INVENTION

According to the present invention, a film having excellent wettability to a substrate and being less prone to turbidity and roughness when forming the film can be formed safely with less environmental load, while reducing the deterioration of the film quality due to degradation of a solvent during the film formation. The present invention further provides an insulating film and an electronic part having excellent, well-balanced heat resistance, electrical properties and mechanical strength.

## BRIEF DESCRIPTION OF THE DRAWINGS

Figure 1 is a cross-sectional schematic view showing an example of the mounted (circuit) board using the insulating film of the present invention.
Figure 2 is a cross-sectional schematic view showing an example of the mounted (circuit) board using the insulating film of the present invention.

## DESCRIOTION OF EMBODIMENTS

«Resin composition»

The resin composition of the present invention comprises a polymer (I) having a specific structure; and at least one kind of organic solvent (II) selected from the group consisting of ether solvents, ketone solvents, ester solvents and amide solvents.
Due to comprising the polymer (I) and the organic solvents (II), the resin composition of the present invention has excellent heat resistance, optical transparency and the like. By using the composition, a uniform film having less turbidity and roughness can be formed safely, easily and with less adverse effects to human body and to the environment. While the resin composition of the present invention is capable of forming a thin to thick film with superior film characteristics, a film excellent in flatness, particularly a thin film excellent in film characteristics can be formed due to the composition's superior wettability to the substrate when forming the film.
An (insulating) film obtained from the resin composition comprising the polymer (I) has superior and well-balanced heat resistance, mechanical strength and electrical properties and the like. Therefore, the composition is suitably used for producing a semiconductor element, a display element, a mounted board and the like. Besides having excellent properties described above, the (insulating) film obtained from the resin composition comprising the polymer (I) is soluble in a poor solvent of polyimide such as γ-butyrolactone. Therefore, the composition is suitably used for producing a protective film for protecting elements, such as electrodes of an organic thin film transistor with a gate insulator consisting of polyimide.

<Polymer (I)>

The polymer (I) comprises at least one structural unit (i) selected from the group consisting of structural units

represented by the following formula (1) and structural units represented by the following formula (2).

The polymer (I) is excellent in heat resistance, optical transparency and the like, and therefore can be suitably used as a material for films, such as a film for light guide plate, a film for polarizing plate, a film for display, a film for optical disc, a transparent conductive film, a film for waveguide plate, a film for printed circuit board and the like. Particularly, it can be suitably used as a material for various film condensers, insulating films and protective films, which require thin film formation.

Due to comprising the structural unit (i), the polymer (I) is an aromatic polyether having a glass transition temperature in a range from 230 to 350°C. An (insulating) film obtained from the resin composition comprising such a polymer has excellent heat resistance and electrical properties.

[Chem. 5]

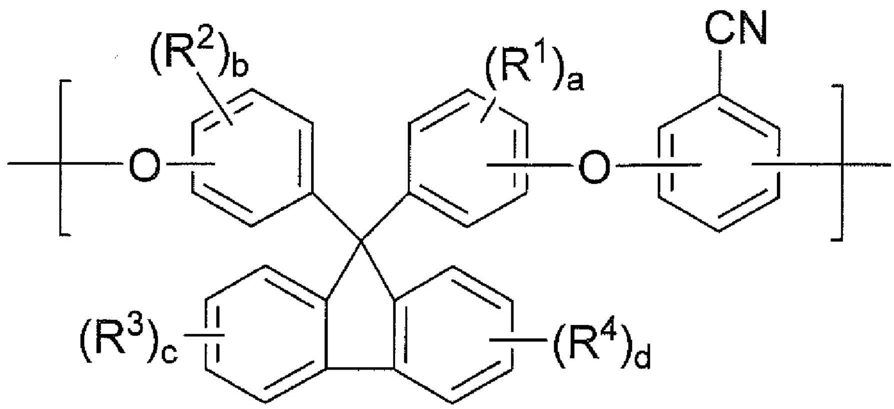

(1)

In the formula (1), $R^1$ to $R^4$ are each independently a monovalent organic group having 1 to 12 carbon atoms; and "a" to "d" are each independently an integer of from 0 to 4, preferably 0 or 1, and more preferably 0.

Examples of the monovalent organic group having 1 to 12 carbon atoms include a monovalent hydrocarbon group having 1 to 12 carbon atoms, and a monovalent organic group having 1 to 12 carbon atoms and containing at least one kind of atom selected from the group consisting of an oxygen atom and a nitrogen atom.

Examples of the monovalent hydrocarbon group having 1 to 12 carbon atoms include a linear or branched hydrocarbon group having 1 to 12 carbon atoms, an alicyclic hydrocarbon group having 3 to 12 carbon atoms and an aromatic hydrocarbon group having 6 to 12 carbon atoms.

The linear or branched hydrocarbon group having 1 to 12 carbon atoms is preferably a linear or branched hydrocarbon group having 1 to 8 carbon atoms, and more preferably a linear or branched hydrocarbon group having 1 to 5 carbon atoms.

Specific preferable examples of the linear or branched hydrocarbon group having 1 to 12 carbon atoms include methyl groups, ethyl groups, n-propyl groups, isopropyl groups, n-butyl groups, sec-butyl groups, tert-butyl groups, n-pentyl groups, n-hexyl groups and n-heptyl groups.

The alicyclic hydrocarbon group having 3 to 12 carbon atoms is preferably an alicyclic hydrocarbon group having 3 to 8 carbon atoms, and more preferably an alicyclic hydrocarbon group having 3 or 4 carbon atoms.

Specific preferable examples of the alicyclic hydrocarbon group having 3 to 12 carbon atoms include cycloalkyl groups such as a cyclopropyl group, a cyclobutyl group, a cyclopentyl group and a cyclohexyl group; and cycloalkenyl groups such as a cyclobutenyl group, a cyclopentenyl group and a cyclohexenyl group. A binding site of the alicyclic hydrocarbon group may be at any carbon on the alicyclic ring.

Examples of the aromatic hydrocarbon group having 6 to 12 carbon atoms include phenyl groups, biphenyl groups, and naphthyl groups. A binding site of the aromatic hydrocarbon group may be at any carbon on the aromatic ring.

Examples of the organic group having 1 to 12 carbon atoms and containing an oxygen atom include an organic group having a hydrogen atom, a carbon atom and an oxygen atom. Among these, preferable examples include an organic group having 1 to 12 carbon atoms in total and containing a hydrocarbon group and an ether bond, a carbonyl group or an ester bond.

Examples of the organic group having 1 to 12 carbon atoms in total and containing an ether bond include an alkoxy group having 1 to 12 carbon atoms, an alkenyloxy group having 2 to 12 carbon atoms, an alkynyloxy group having 2 to 12 carbon atoms, an aryloxy group having 6 to 12 carbon atoms, and an alkoxyalkyl group having 2 to 12 carbon atoms. Specific examples thereof include methoxy groups, ethoxy groups, propoxy groups, isopropyloxy groups, butoxy

groups, phenoxy groups, propenyloxy groups, cyclohexyloxy groups, methoxy methyl groups, and the like.

Examples of the organic group having 1 to 12 carbon atoms in total and containing a carbonyl group include an acyl group having 2 to 12 carbon atoms. Specific examples thereof include acetyl groups, propionyl groups, isopropionyl groups, and benzoyl groups.

Examples of the organic group having 1 to 12 carbon atoms in total and containing an ester bond include an acyloxy group having 2 to 12 carbon atoms. Specific examples thereof include acetyloxy groups, propionyloxy groups, isopropionyloxy groups, and benzoyloxy groups.

Examples of the organic group having 1 to 12 carbon atoms and containing a nitrogen atom include an organic group containing a hydrogen atom, a carbon atom and a nitrogen atom. Specific examples thereof include cyano groups, imidazole groups, triazole groups, benzimidazole groups, and benzotriazole groups.

Examples of the organic group having 1 to 12 carbon atoms and containing an oxygen atom and a nitrogen atom include an organic group containing a hydrogen atom, a carbon atom, an oxygen atom, and a nitrogen atom. Specific examples thereof include oxazole groups, oxadiazole groups, benzoxazole groups, and benzoxadiazole groups.

The $R^1$ to $R^4$ in the formula (1) are preferably monovalent hydrocarbon groups having 1 to 12 carbon atoms, more preferably linear or branched hydrocarbon groups having 1 to 12 carbon atoms or aromatic hydrocarbon groups having 6 to 12 carbon atoms, still more preferably, methyl groups or phenyl groups.

[Chem. 6]

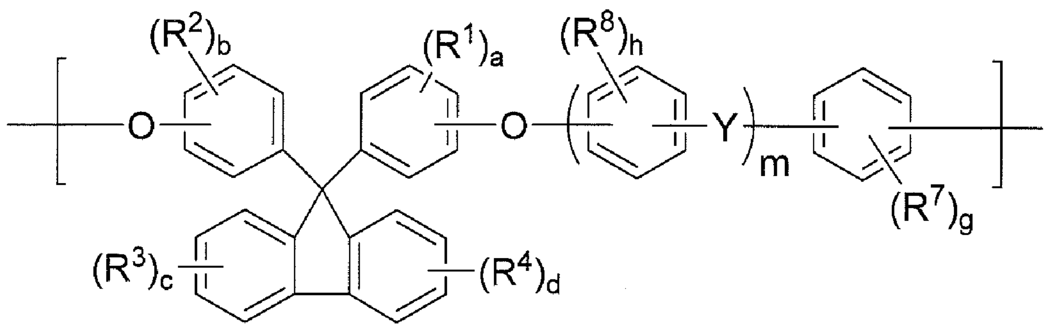

(2)

In the formula (2), $R^1$ to $R^4$ and "a" to "d" are each independently defined in the same manner as described for $R^1$ to $R^4$ and "a" to "d" of the formula (1); Y is a single bond, $-SO_2-$or >C=O; $R^7$ and $R^8$ are each independently a halogen atom, a monovalent organic group having 1 to 12 carbon atoms or a nitro group; and "m" is 0 or 1;provided that when "m" is 0, $R^7$ is not a cyano group. "g" and "h" are each independently an integer of from 0 to 4, preferably 0.

Examples of the monovalent organic group having 1 to 12 carbon atoms include organic groups as described for the monovalent organic group having 1 to 12 carbon atoms in the formula (1), and the like.

In terms of optical properties, heat resistance and mechanical properties, a molar ratio of the structural unit (1) to the structural unit (2) of the polymer (I) (provided that the sum of both structural units (structural unit (1)+structural unit(2)) is 100) is preferably such that structural unit (1) : structural unit (2) =50 : 50 to 100:0, more preferably such that structural unit (1) :structural unit (2)=70:30 to 100:0, still more preferably such that structural unit (1):structural unit (2) =80:20 to 100:0.

As used herein, mechanical properties refer to properties of the polymer, such as tensile strength, elongation at break and tensile modulus of elasticity.

Additionally, the polymer (I) may further comprise at least one structural unit (ii) selected from the group consisting of structural units represented by formula (3) below and structural units represented by formula (4) below. The polymer (I) preferably comprises this structural unit (ii) because the film obtained from the composition comprising the polymer (I) has improved mechanical properties.

[Chem. 7]

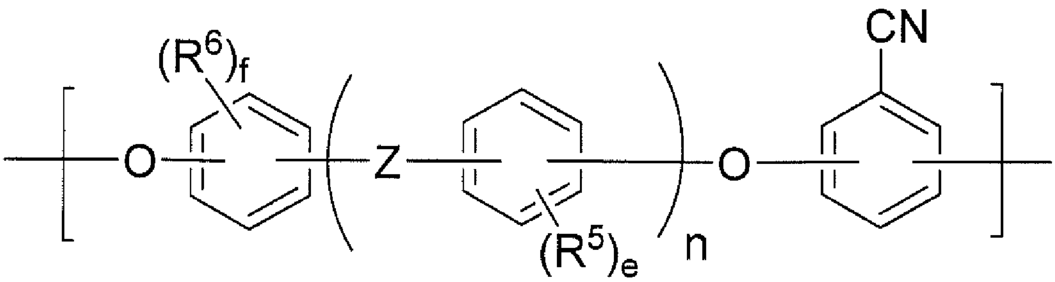

(3)

In the formula (3), $R^5$ and $R^6$ are each independently a monovalent organic group having 1 to 12 carbon atoms; Z is a single bond, -O-, -S-, $-SO_2-$, >C=O, -CONH-, -COO- or a divalent organic group having 1 to 12 carbon atoms; "n" is 0 or 1. "e" and "f" are each independently an integer of from 0 to 4, preferably 0.

Examples of the monovalent organic group having 1 to 12 carbon atoms include organic groups as described for the monovalent organic group having 1 to 12 carbon atoms in the formula (1), and the like.

Examples of the divalent organic group having 1 to 12 carbon atoms include a divalent hydrocarbon group having 1 to 12 carbon atoms, a divalent halogenated hydrocarbon group having 1 to 12 carbon atoms, a divalent organic group having 1 to 12 carbon atoms and containing at least one kind of atom selected from the group consisting of an oxygen atom and a nitrogen atom, and a divalent halogenated organic group having 1 to 12 carbon atoms and containing at least one kind of atom selected from the group consisting of an oxygen atom and a nitrogen atom.

Examples of the divalent hydrocarbon group having 1 to 12 carbon atoms include a linear or branched divalent hydrocarbon group having 1 to 12 carbon atoms, a divalent alicyclic hydrocarbon group having 3 to 12 carbon atoms and a divalent aromatic hydrocarbon group having 6 to 12 carbon atoms.

Examples of the linear or branched divalent hydrocarbon group having 1 to 12 carbon atoms include methylene groups, ethylene groups, trimethylene groups, isopropylidene groups, pentamethylene groups, hexamethylene groups and heptamethylene groups.

Examples of the divalent alicyclic hydrocarbon group having 3 to 12 carbon atoms include cycloalkylene groups such as a cyclopropylene group, a cyclobutylene group, a cyclopentylene group, and a cyclohexylene group; and cycloalkenylene groups such as a cyclobutenylene group, a cyclopentenylene group and a cyclohexenylene group. A binding site of the alicyclic hydrocarbon group may be at any carbon on the alicyclic ring.

Examples of the divalent aromatic hydrocarbon group having 6 to 12 carbon atoms include phenylene groups, naphthylene groups and biphenylene groups. A binding site of the aromatic hydrocarbon group may be at any carbon on the aromatic ring.

Examples of the divalent halogenated hydrocarbon group having 1 to 12 carbon atoms include a linear or branched divalent halogenated hydrocarbon group having 1 to 12 carbon atoms, a divalent halogenated alicyclic hydrocarbon group having 3 to 12 carbon atoms and a divalent halogenated aromatic hydrocarbon group having 6 to 12 carbon atoms.

Examples of the linear or branched divalent halogenated hydrocarbon group having 1 to 12 carbon atoms include difluoromethylene groups, dichloromethylene groups, tetrafluoroethylene groups, tetrachloroethylene groups, hexafluorotrimethylene groups, hexachlorotrimethylene groups, hexafluoroisopropylidene groups and hexachloroisopropylidene groups.

Examples of the divalent halogenated alicyclic hydrocarbon group having 3 to 12 carbon atoms include a group obtained by substituting at least one hydrogen atom of a group exemplified in the divalent alicyclic hydrocarbon group having 3 to 12 carbon atoms with a fluorine atom, a chlorine atom, a bromine atom or an iodine atom.

Examples of the divalent halogenated aromatic hydrocarbon group having 6 to 12 carbon atoms include a group obtained by substituting at least one hydrogen atom of a group recited as an example for the divalent aromatic hydrocarbon group having 6 to 12 carbon atoms with a fluorine atom, a chlorine atom, a bromine atom or an iodine atom.

Examples of the organic group having 1 to 12 carbon atoms and containing at least one kind of atom selected from the group consisting of an oxygen atom and a nitrogen atom include an organic group containing a hydrogen atom, a carbon atom, an oxygen atom and/or a nitrogen atom. Preferable examples thereof include a divalent organic group having 1 to 12 carbon atoms in total and containing a hydrocarbon group and an ether bond, a carbonyl group, an ester bond and/or an amide bond.

Specific examples of the divalent halogenated organic group having 1 to 12 carbon atoms and containing at least one kind of atom selected from the group consisting of an oxygen atom and a nitrogen atom include a group obtained by substituting at least one hydrogen atom of a group recited as an example for the divalent organic group having 1 to 12 carbon atoms and containing at least one kind of atom selected from the group consisting of an oxygen atom and a nitrogen atom with a fluorine atom, a chlorine atom, a bromine atom or an iodine atom.

Z in the formula (3) is preferably a single bond, -O-, $-SO_2-$, >C=O or a divalent organic group having 1 to 12

carbon atoms; and more preferably a single bond, a divalent hydrocarbon group having 1 to 12 carbon atoms or a divalent halogenated hydrocarbon group having 1 to 12 carbon atoms. The divalent hydrocarbon group having 1 to 12 carbon atoms is preferably a linear or branched divalent hydrocarbon group having 1 to 12 carbon atoms or a divalent alicyclic hydrocarbon group having 3 to 12 carbon atoms. The divalent halogenated hydrocarbon group having 1 to 12 carbon atoms is preferably a divalent linear or branched halogenated hydrocarbon group having 1 to 12 carbon atoms.

[Chem. 8]

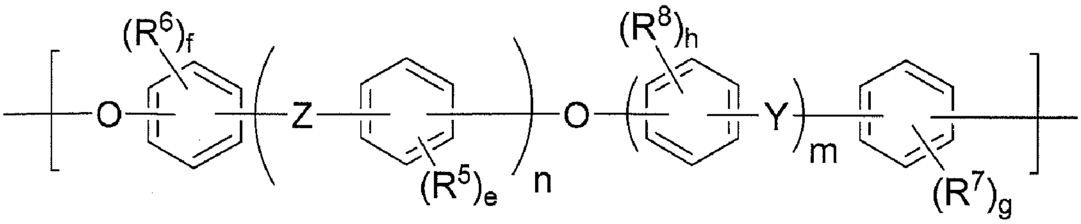

(4)

In the formula (4), $R^7$, $R^8$, Y, "m", "g" and "h" are each independently defined in the same manner as described for $R^7$, $R^8$, Y, "m", "g" and "h" of the formula (2); and $R^5$, $R^6$, Z, "n", "e" and "f" are each independently defined in the same manner as described for $R^5$, $R^6$, Z, "n" "e" and "f" of the formula (3). Note that when "m" is 0, $R^7$ is not a cyano group.

In terms of optical properties, heat resistance and mechanical properties, a molar ratio of the structural unit (i) to the structural unit (ii) of the polymer (I) (provided that the sum of the structural units (i) + (ii) is 100) is preferably such that (i) : (ii) =50: 50 to 100: 0, more preferably such that (i) : (ii) =70: 30 to 100: 0, still more preferably such that (i) : (ii) =80: 20 to 100: 0.

As used herein, mechanical properties refer to properties of the polymer, such as tensile strength, elongation at break and tensile modulus of elasticity.

In terms of optical properties, heat resistance, and mechanical properties, in the polymer (I), the structural unit (i) and the structural unit (ii) preferably constitute not less than 70 mol% of all the structural units, and more preferably constitute not less than 95 mol% of all the structural units.

[Process for synthesizing the polymer (I)]

The polymer can be obtained, for example, by reacting a component (hereinafter referred to as "component (A)") comprising at least one compound selected from the group consisting of a compound represented by the formula (5) below (hereinafter referred to as "compound (5)") and a compound represented by the formula (7) below (hereinafter referred to as "compound (7)"), and a component (hereinafter referred to as "component (B)") comprising a compound represented by the formula (6) below.

[Chem. 9]

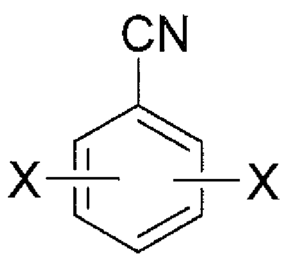

(5)

In the formula (5), X are each independently a halogen atom, preferably a fluorine atom.

[Chem. 10]

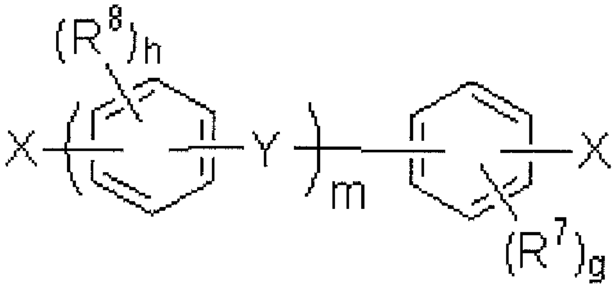

(7)

In the formula (7), $R^7$, $R^8$, Y, "m", "g" and "h" are each independently defined in the same manner as described for $R^7$, $R^8$, Y, "m", "g" and "h" of the formula (2) ; and X are each independently defined in the same manner as described for X of the formula (5) . Provided that when "m" is 0, $R^7$ is not a cyano group.

[Chem. 11]

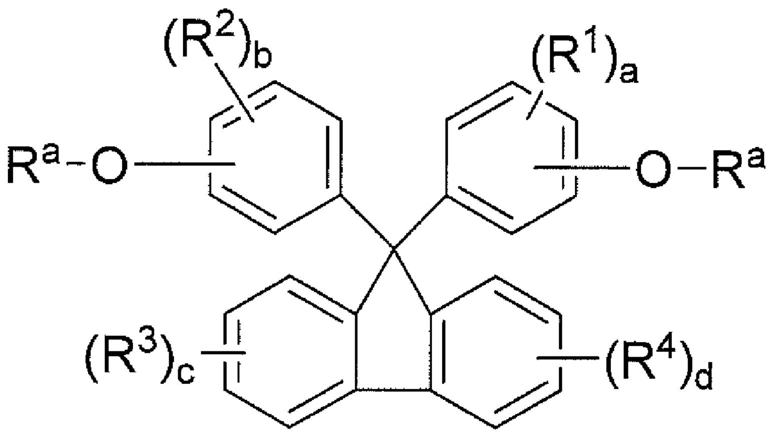

(6)

In the formula (6), $R^a$ are each independently a hydrogen atom, a methyl group, an ethyl group, an acetyl group, a methanesulfonyl group or a trifluoromethylsulfonyl group. Among these, a hydrogen atom is preferred. In the formula (6), $R^1$ to $R^4$ and "a" to "d" are each independently defined in the same manner as described for $R^1$ to $R^4$ and "a" to "d" of the formula (1).

Specific examples of the compound (5) include 2, 6- difluorobenzonitrile, 2, 5- difluorobenzonitrile, 2, 4- difluorobenzonitrile, 2, 6- dichlorobenzonitrile, 2, 5- dichlorobenzonitrile, 2, 4- dichlorobenzonitrile, and reactive derivatives thereof. In particular, in terms of reactivity, cost performance and the like, 2, 6- difluorobenzonitrile and 2, 6- dichlorobenzonitrile are preferably used. These compounds can be used in combination of two or more kinds.

Specific examples of the compound represented by formula (6) (hereinafter referred to as "compound (6) ") include 9, 9- bis (4- hydroxyphenyl) fluorene, 9, 9- bis (3- phenyl- 4- hydroxyphenyl) fluorene, 9, 9- bis (3, 5- diphenyl- 4- hydroxyphenyl) fluorene, 9, 9- bis (4- hydroxy- 3- methylphenyl) fluorene, 9, 9- bis (4- hydroxy- 3, 5- dimethylphenyl) fluorene, 9, 9- bis (4- hydroxy- 3- cyclohexylphenyl) fluorene, and reactive derivatives thereof. Among the above compounds, preferred are 9, 9- bis (4- hydroxyphenyl) fluorene, 9, 9- bis (4- hydroxy- 3- methylpheny) fluorene and 9, 9- bis (3- phenyl- 4- hydroxyphenyl) fluorene. These compounds can be used in combination of two or more kinds.

Specific examples of the compound (7) include 4, 4'- difluorobenzophenone, 4, 4'- difluorodiphenylsulfone, 2, 4'- difluorobenzophenone, 2, 4'- difluorodiphenylsulfone, 2, 2'- difluorobenzophenone, 2, 2'- difluorodiphenylsulfone, 3, 3'- dinitro- 4, 4'- difluorobenzophenone, 3, 3'- dinitro- 4, 4'- difluorodiphenylsulfone, 4, 4'- dichlorobenzophenone, 4, 4'- dichlorodiphenylsulfone, 2, 4'- dichlorobenzophenone, 2, 4'- dichlorodiphenylsulfone, 2, 2'- dichlorobenzophenone, 2, 2'- dichlorodiphenylsulfone, 3, 3'- dinitro- 4, 4'- dichlorobenzophenone, 3, 3'- dinitro- 4, 4'- dichlorodiphenylsulfone, and the like. Among the above compounds, preferred are 4, 4'- difluorobenzophenone, 4, 4'- difluorodiphenysulfone and 4, 4'- dichlorodiphenylsulfone. These compounds can be used in combination of two or more kinds.

100 mol% of the component (A) preferably contains from 80 mol% to 100 mol% and more preferably from 90 mol% to 100 mol% of the at least one compound selected from the group consisting of the compound (5) and the

compound (7).

The component (B) preferably comprises a compound represented by the formula (8) below as needed. 100 mol% of the component (B) preferably contains from 50 mol% to 100 mol%, more preferably from 80 mol% to 100 mol%, still more preferably from 90 mol% to 100 mol% of the compound (6).

[Chem. 12]

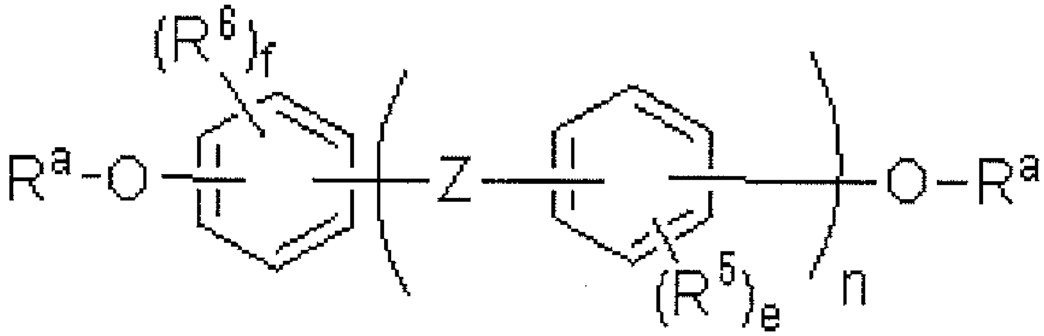

(8)

In the formula (8), $R^5$, $R^6$, Z, "n", "e" and "f" are each independently defined in the same manner as described for $R^5$, $R^6$, Z, "n", "e" and "f" in the formula (3); and $R^a$ is independently defined in the same manner as described for $R^a$ in the formula (6).

Examples of the compound represented by the formula (8) include hydroquinone, resorcinol, 2- phenyl hydroquinone, 4, 4'- biphenol, 3, 3'- biphenol, 4, 4'- dihydroxydiphenylsulfone, 3, 3'- dihydroxydiphenylsulfone, 4, 4'- dihydroxybenzophenone, 3, 3'- dihydroxybenzophenone, 2, 2- bis (4- hydroxyphenyl) propane, 1, 1- bis (4- hydroxyphenyl) cyclohexane, 2, 2- bis (4- hydroxyphenyl)- 1, 1, 1, 3, 3, 3- hexafluoropropane, and reactive derivatives thereof. These compounds can be used in combination of two or more kinds.

Among the above compounds, resorcinol, 4, 4'- biphenol, 2, 2- bis (4- hydroxyphenyl) propane, 1, 1- bis (4- hydroxyphenyl) cyclohexane, and 2, 2- bis (4- hydroxyphenyl)- 1, 1, 1, 3, 3, 3- hexafluoropropane are preferred in terms of reactivity, mechanical properties, and solubility, and 4, 4'- biphenol is preferred in terms of reactivity and mechanical properties.

More specifically, the polymer (I) can be synthesized via method (I'), described below.

Method (I'): React the component (B) with an alkali metal compound in an organic solvent in order to obtain an alkali metal salt of the component (B); then, react the obtained alkali metal salt with the component (A). By carrying out the reaction of the component (B) and the alkali metal compound in the presence of the component (A), the alkali metal salt of the component (B) can be reacted with the component (A).

Examples of the alkali metal compound used in the reaction include an alkali metal such as lithium, potassium and sodium; an alkali metal hydride such as lithium hydride, potassium hydride and sodium hydride; an alkali metal hydroxide such as lithium hydroxide, potassium hydroxide and sodium hydroxide; an alkali metal carbonate such as lithium carbonate, potassium carbonate and sodium carbonate; and an alkali metal hydrogen carbonate such as lithium hydrogen carbonate, potassium hydrogen carbonate and sodium hydrogen carbonate. These can be used in a single kind or in combination of two or more kinds.

The alkali metal compound is used in an amount such that the amount of metal atoms in the alkali metal compound, with respect to all -O-$R^a$ in the component (B), is typically from 1 to 3 times by equivalents, preferably from 1.1 to 2 times by equivalents, and more preferably from 1.2 to 1.5 times by equivalents.

Examples of the organic solvent used in the reaction include N, N- dimethylacetamide, N, N- dimethylformamide, N- methyl- 2- pyrrolidone, 1, 3- dimethyl- 2- imidazolidinone, γ- butyllactone, sulfolane, dimethylsulfoxide, diethylsulfoxide, dimethylsulfone, diethylsulfone, diisopropylsulfone, diphenylsulfone, diphenylether, benzophenone, dialkoxybenzene (the number of carbon atoms of the alkoxy group: 1 to 4) and trialkoxybenzene (the number of carbon atoms of the alkoxy group: 1 to 4) . Among these solvents, particularly preferred are polar organic solvents having high dielectric constant such as N- methyl- 2- pyrrolidone, N, N- dimethylacetamide, sulfolane, diphenylsulfone and dimethylsulfoxide. These can be used in a single kind or in combination of two or more kinds.

Furthermore, a solvent azeotropic with water, such as benzene, toluene, xylene, hexane, cyclohexane, octane, chlorobenzene, dioxane, tetrahydrofuran, anisole and phenetole can be used in the reaction. These can be used in a single kind or in combination of two or more kinds.

Usage ratios of the component (A) and the component (B) when the total of the component (A) and the component

(B) equals 100 mol% are preferably such that the component (A) is used in an amount of not less than 45 mol% and not more than 55 mol%, more preferably not less than 50 mol% and not more than 52 mol%, still more preferably more than 50 mol% and not more than 52 mol%; and preferably such that the component (B) is used in an amount of not less than 45 mol% and not more than 55 mol%, more preferably not less than 48 mol% and not more than 50 mol%, still more preferably not less than 48 mol% and less than 50 mol%.

The reaction temperature is preferably in a range from 60 to 250°C and more preferably from 80 to 200°C. The reaction time is preferably in a range from 15 minutes to 100 hours and more preferably from 1 hour to 24 hours.

[Physical properties and the like of the polymer (I)]

The polymer (I) preferably has a glass transition temperature (Tg) as measured by differential scanning calorimetry (DSC, heating rate: 20°C /min) of 230 to 350°C, more preferably 240 to 330°C, still more preferably 250 to 300°C. The glass transition temperature of the polymer (I) is measured using, for example, 8230 DSC measuring apparatus manufactured by Rigaku Corporation (heating rate: 20°C /min).

The polymer (I) preferably has a weight average molecular weight (Mw) in terms of polystyrene, as measured using a HLC-8220 GPC apparatus manufactured by Tosoh Corporation (column: TSK gel α-M; developing solvent: tetrahydrofuran (hereinafter, also referred to as "THF")), of from 5, 000 to 500, 000, more preferably from 15,000 to 400,000, still more preferably from 30,000 to 300,000.

The polymer (I) preferably has a pyrolysis starting temperature as measured by thermogravimetric analysis method (TGA) of 400°C or higher, more preferably 425°C or higher, more preferably 450°C or higher.
The polymer (I) preferably has 5% weight reduction temperature of 450°C or higher, more preferably 500°C or higher.

<Organic solvent (II)>

The organic solvent (II) used in the resin composition of the present invention comprises at least one kind of organic solvent selected from the group consisting of ether solvents, ketone solvents, ester solvents and amide solvents. The organic solvent (II) may be one kind of organic solvent selected from the group consisting of ether solvents, ketone solvents, ester solvents and amide solvents, or may be a mixed solvent of two or more solvents selected from the group consisting of ether solvents, ketone solvents, ester solvents and amide solvents.

Due to comprising the organic solvent (II), the resin composition of the present invention exhibits excellent wettability to the substrate when applying the composition thereon. By using the composition, a uniform film having less turbidity and roughness can be formed safely, easily and with less adverse effects to human body and to the environment. Furthermore, the use of the organic solvent (II) is preferred, because the deterioration of the film quality due to degradation of the solvent is less likely to occur when forming the film from the composition.

By using the organic solvent (II), a film having excellent wettability to the substrate and being less prone to turbidity and roughness can be formed, compared to using conventional methylene chloride. Moreover, the use of non-halogenated solvents allows for increased safety to human body, while reducing the deterioration of the film quality due to degradation of the solvent during the film formation.

The ketone solvents are effective in reducing turbidity in the films obtained.
As the ketone solvent, preferred are ketones having not less than 4 and not more than 10 carbon atoms, and more preferred are ketones having not less than 4 and not more than 6 carbon atoms in terms of boiling point and cost performance. Specific examples of the preferred ketone solvent include dialkyl ketones such as methyl ethyl ketone, methyl-n-propyl ketone, methyl-iso-propyl ketone, diethyl ketone, methyl-n-butyl ketone, methyl-iso-butyl ketone, methyl-sec-butyl ketone, methyl-tert-butyl ketone; cyclic ketones such as clyclo pentanone, clyclo hexanone, clyclo heptanon; and the like. Among these, preferred are methyl ethyl ketone and clyclo hexanone, and more preferred is clyclo hexanone. These can be used in a single kind or in combination of two or more kinds.

The ester solvents are effective in reducing turbidity in the films obtained.
As the ester solvent, preferred are esters having not less than 3 and not more than 10 carbon atoms, and more preferred are esters having not less than 3 and not more than 6 carbon atoms. Examples of the preferred ester solvent include alkyl esters such as ethyl acetate, propyl acetate, iso- propyl acetate and butyl acetate; alkoxy alkyl esters such as 1-methoxy- 2- propyl acetate; cyclic esters such as β- propiolactone, α- methyl- γ- butyrolactone, γ- butyrolactone, δ-caprolactone, γ- valerolactone; and the like. Among these, γ- butyrolactone is preferred. These can be used in a single kind or in combination of two or more kinds.

As the amide solvent, preferred are amides having not less than 3 and not more than 10 carbon atoms, and more preferred are amides having not less than 3 and not more than 6 carbon atoms. Examples of the preferred amide solvent include alkyl amides such as N, N- dimethylformamide, N, N- dimethyl acetamide, N, N- dipentyl acetamide, N, N- di- tert- butyl acetamide; alkoxy alkyl amides such as N, N- dimethoxy propyl acetamide, 3- methoxy- N, N- dimethyl propanamide, 3- n- butoxy- N, N- dimethyl propanamide; cyclic amides such as 1, 3- dimethyl- 2- imidazolidinone, N-methyl- 2- pyrrolidone; and the like. Among these, N, N- dimethyl acetamide and N- methyl- 2- pyrrolidone are preferred in terms of coatability and economical viewpoint. These can be used in a single kind or in combination of two or more kinds.

When the amide solvent alone is used as the organic solvent (II), it provides advantages in simplifying the facilities related to recovery and recycling, or to recovery of the solvents.

The resin composition comprising the ether solvent is suitable for forming a film having superior film quality, because the ether solvents have less degradation compared to the ketone solvents, ester solvents and amide solvents As the ether solvent, preferred are ethers having not less than 3 and not more than 10 carbon atoms, and more preferred are ethers having not less than 3 and not more than 7 carbon atoms. The specific examples of the preferred ether solvent include mono-or di-alkyl ethers such as ethylene glycol, diethylene glycol; cyclic ethers such as dioxane and tetrahydrofuran; aromatic ethers such as anisole; and the like. Among these, anisole and tetrahydrofuran are preferred. These can be used in a single kind or in combination of two or more kinds.

In terms of reducing cissing during the film formation and reducing turbidity in the films obtained, the organic solvent (II) used in the resin composition of the present invention is preferably a mixed solvent comprising at least one kind of organic solvent selected from ketone solvents, ester solvents and ether solvents; and an amide solvent. The mixed solvent more preferably comprises a cyclic ketone solvent and an amide solvent; or an ether solvent and an amide solvent.

When the mixed solvent is used as the organic solvent (II), the mixed solvent comprises preferably 5 to 95 parts by mass of the amide solvent based on 100 parts by mass of the total organic solvents, more preferably 10 to 90 parts by mass, still more preferably 30 to 70 parts by mass. By using the mixed solvent comprising the amide solvent in an amount within the range described above, the uniformity (flatness) of the film obtained can be increased. In the present invention, the term "total organic solvents" refers to any organic solvent comprised in the resin composition of the present invention.

When the mixed solvent is used as the organic solvent (II), the total amount of the ketone solvent, the ester solvent and the ether solvent used therein based on 100 parts by mass of the total organic solvents is preferably 5 to 95 parts by mass, more preferably 10 to 90 parts by mass, still more preferably 30 to 70 parts by mass. By using the mixed solvent comprising the ketone solvent, the ester solvent and the ether solvent in an amount within the range described above, the turbidity in the film can further be reduced during the film formation. Furthermore, the resin composition comprising the ketone solvent, the ester solvent and the ether solvent in an amount within the range described above is useful as a resin composition for forming a thin film on a substrate.

Typically, a resin composition having high viscosity (concentration) is used for forming a self- supported film, while a resin composition having low viscosity (concentration) is used for forming a thin film on a substrate. In thin film formation, occurrence of cissing due to low viscosity when coating the composition on the substrate has been a problem. By using the resin composition comprising the ketone solvent, the ester solvent and the ether solvent in an amount within the range described above, a high- quality thin film with less cissing can be formed.

<Resin Composition>

The resin composition is preferably prepared by a method in which the polymer (I) is isolated (purified) as a solid component from the mixture obtained by the above process (I') of the polymer (I) and the solvent used in the reaction, and then the solid component is redissolved in the organic solvent (II). In the process (I'), when the organic solvent (II) is used as a solvent for the reaction, the resin composition of the present invention may be the solution in which by-product salts are removed from the mixture obtained by the process (I') of the polymer (I) and the solvent used in the reaction.

The isolation (purification) of the polymer (I) as a solid component can be carried out, for example, by reprecipitating the polymer (I) in a poor solvent for the polymer (I) such as methanol, filtering the solution, and then drying a cake under reduced pressure.

The viscosity of the resin composition of the present invention is, depending on a molecular weight or a concentration of the polymer (I), typically 500 to 50, 000 mPa·s, preferably 700 to 30,000 mPa·s. When the viscosity of the resin composition is within the above range, excellent retentivity of the resin composition during the film formation is achieved, and the film thickness is easily controlled, leading to easy formation of a film.

When a thin film is formed from the resin composition of the present invention, the viscosity of the composition is typically 500 to 10,000 mPa·s, preferably 700 to 5,000 mPa·s.

In a common interpretation, a thin film in the present invention means a film which has a film thickness of not more than 25 $\mu$m and does not have sufficient self-supporting property. This thin film generally means a film which is formed on a substrate.

The polymer concentration in the resin composition in which the polymer (I) has been dissolved is preferably adjusted so that its viscosity is within the range described above. Depending on the molecular weight of the polymer (I), the polymer concentration is typically from 3 to 40% by mass, preferably from 5 to 25% by mass. When the concentration

of the polymer (I) in the resin composition is within the range described above, the formation of a thin film is possible, pinhole can hardly occur, and a film with excellent surface smoothness can be formed.

When a thin film is formed from the resin composition of the present invention, the polymer concentration in the composition is typically 3 to 30% by weight, preferably 5 to 20% by weight.

The resin composition can further contain an anti-aging agent, and thereby the film obtained from the resin composition can have much improved durability.

Preferable examples of the anti-aging agent include hindered phenolic compounds.

Examples of hindered phenolic compounds employable in the present invention include triethyleneglycol- bis [3- (3- tert- butyl- 5- methyl- 4- hydroxypheny l) propionate], 1, 6- hexanediol- bis [3- (3, 5- di- tert- butyl- 4- hydroxyphenyl) propi onate], 2, 4- bis- (n- octylthio)- 6- (4- hydroxy- 3, 5- di- tert- butylanilino)- 3, 5- triazine, pentaerythritoltetrakis [3- (3, 5- tert- butyl 4- hydroxyphenyl) propionate], 1, 1, 3- tris [2- methyl- 4- [3- (3, 5- di- tert- butyl- 4- hydroxyphenyl) p ropionyloxy]- 5- tert- butylphenyl] butane, 2, 2- thio- diethylenebis [3- (3, 5- di- tert- butyl- 4- hydroxyphenyl) p ropionate], octadecyl- 3- (3, 5- di- tert- butyl- 4- hydroxyphenyl) propionate, N, N- hexamethylenebis (3, 5- di- tert- butyl- 4- hydroxy- hydrocinnamami de), 1, 3, 5- trimethyl- 2, 4, 6- tris (3, 5- di- tert- butyl- 4- hydroxybenzyl) benzene, tris- (3, 5- di- tert- butyl- 4- hydroxybenzyl)- isocyanurate, and 3, 9- bis [2- {3- (3- tert- butyl- 4- hydroxy- 5- methylphenyl) propionyl oxy}- 1, 1- dimethylethyl]- 2, 4, 8, 10- tetraoxaspiro [5.5] undecane.

When an anti-aging agent is compounded in the resin composition, a compounded amount of the anti-aging agent is preferably from 0.01 to 10 parts by weight per 100 parts by weight of the polymer (I).

«Film»

The film of the present invention is formed from the resin composition. Example of the film includes an insulating film.

<Process for forming a Film>

Examples of the process for forming a film include processes comprising a step of applying the resin composition on a substrate to form a coating film, and a step of removing the organic solvent from the coating film.

Examples of the process for applying the resin composition on a substrate to form a coating film include roll coating, gravure coating, spin coating and a process using a doctor blade.

The thickness of the coating film is not particularly limited. It is, for example, 0.1 to 250 μm, preferably 2 to 150 μm, and more preferably 5 to 125 μm.

Examples of the substrate include a polyethylene terephthalate (PET) film, a silicon wafer, a glass wafer, a glass substrate and a SUS plate. In particular, the use of the resin composition enables the formation of a thin film on a silicon wafer, a glass wafer, a glass substrate and a SUS plate that have a low affinity to resins or solvents.

The process for removing the organic solvent from a coating film can be carried out, in particular, by heating the coating film. By heating a coating film, the organic solvent in the coating film can be evaporated off. The heating conditions can be appropriately determined depending on the substrate and the polymer, provided that the organic solvent can be removed. For example, the heating temperature is preferably from 30 to 300°C, more preferably from 40 to 250°C, and even more preferably from 50 to 230°C. The heating time is preferably from 10 minutes to 5 hours.

The heating may be carried out in two or more stages. A specific method includes drying at a temperature of from 30°C to 80°C for from 10 minutes to 2 hours, and then heating at a temperature of from 100°C to 250°C for from 10 minutes to 2 hours. As needed, drying may be carried out under reduced pressure.

The heating atmosphere is not particularly limited, but the heating is preferably carried out under normal atmospheric conditions or under an inert gas atmosphere, or the like; and more preferably is carried out under an inert gas atmosphere. From the perspective of coloration, examples of the inert gas include nitrogen, argon, helium and the like, and of which nitrogen is preferable.

In the drying, the coating film formed on the substrate may be dried together with the substrate. However, from the standpoint that the properties of the substrate have no effect, it is preferable that a certain degree of drying is carried out (e.g., when carrying out the heating in two or more stages as described above, after the drying in the first stage), then the coating film formed on the substrate is delaminated from the substrate and thereafter dried.

Furthermore, a calcinating step for calcinating the coating film from which the solvent has been removed is preferably included. When a film is produced, by passing through a calcinating step, a film with low thermal shrinkage can be produced.

In the calcination, the coating film formed on the substrate may be calcinated together with the substrate. However, from the standpoint that the properties of the substrate have no effect, the calcination is carried out preferably after the coating film formed on the substrate is delaminated from the substrate. The step for removing the organic solvent may be carried out in the calcinating step or, alternately another step for removing the organic solvent prior to

the calcinating step may be included. In calcination of the coating film delaminated from the substrate, a step for removing the organic solvent from the coating film is preferably included prior to delaminating the coating film from the substrate.

The calcinating step is preferably carried out at a specific temperature. The calcination temperature is preferably from 210°C to 350°C, more preferably from 220°C to 330°C, and even more preferably from 230°C to 320°C. Calcination time is preferably from 10 minutes to 5 hours.

The calcination atmosphere is not particularly limited, but the calcinating is preferably carried out under normal atmospheric conditions or under an inert gas atmosphere, or the like; and more preferably is carried out under an inert gas atmosphere. From the perspective of coloration, examples of the inert gas include nitrogen, argon, helium and the like, and of which nitrogen is preferable.

Depending on the type of substrate used and the application, the obtained film can be used in a delaminated from the substrate or, alternatively, can be used as-is without delamination.

The thickness of the film may be appropriately selected depending on the desired application thereof, but is preferably from 0.05 to 250 μm, more preferably from 2 to 150 μm, and even more preferably from 10 to 125 μm.

[Physical Properties and the like of the Film]

A glass transition temperature (Tg) of the film measured with a model 8230 DSC measuring apparatus, manufactured by Rigaku Corporation (heating rate: 20°C/min) is preferably 230 to 350°C, more preferably 240 to 330°C, and still more preferably 250 to 300°C.

When the film has such a glass transition temperature, heating or heat treating at a high temperature can be carried out in forming an electrode or a semiconductor layer on the film, and thereby a semiconductor element with particularly high reliability can be easily manufactured.

When the thickness of the film is 20 μm, a total light transmittance of the film in accordance with JIS K7105 transparency testing methods is preferably not less than 85% and more preferably not less than 88%. The total light transmittance can be measured using a haze meter, SC-3H, manufactured by Suga Test Instruments Co., Ltd.

The film has particularly high light transmittance when the transmittance is within this range.

When the thickness of the film is 20 μm, a YI (yellow index) value is preferably not greater than 3.0, more preferably not greater than 2.5, and even more preferably not greater than 2.0. The YI value can be measured using an SM-T color meter, manufactured by Suga Test Instruments Co., Ltd. A film that is not prone to coloration can be obtained when the YI value is within this range.

When the thickness of the film is 20 μm, a YI value after heating for one hour at 230°C in air using a hot air dryer is preferably not greater than 3.0, more preferably not greater than 2.5, and even more preferably not greater than 2.0. A film that is not prone to coloration under high temperatures can be obtained when the YI value is within this range.

A refractive index of the film with respect to 633 nm wavelength light is preferably from 1.55 to 1.75 and more preferably from 1.60 to 1.70. The refractive index can be measured using a prism coupler model 2010 (manufactured by Metricon Corp.).

A tensile strength of the film is preferably from 50 to 200 MPa and more preferably from 80 to 150 MPa. The tensile strength can be measured using a tensile tester 5543 (manufactured by Instron).

An elongation at break of the film is preferably from 5 to 100% and more preferably from 15 to 100%. The elongation at break can be measured using a tensile tester 5543 (manufactured by Instron).

A tensile modulus of elasticity of the film is preferably from 2.5 to 4.0 GPa and more preferably from 2.7 to 3.7 GPa. The tensile modulus of elasticity can be measured using a tensile tester 5543 (manufactured by Instron).

A coefficient of humidity expansion of the film is preferably not greater than 15 ppm/ %RH and more preferably not greater than 12 ppm/ %RH. The coefficient of humidity expansion can be measured using a humidity control option of a MA device (TMA- SS6100, manufactured by SII Nano Technology Inc.) . When the coefficient of expansion of the film is within the range, the film has high dimensional stability (environmental reliability) and, as a result, the film can be more suitably used in light guide plates, polarizing plates, films for display, films for optical disc, transparent conductive films, waveguide plates, printed circuit boards and the like.

The preferred applications of the film include insulating films, protective films and films for various capacitors which are used in electronic parts such as semiconductor elements; display elements including a thin-film transistor-liquid crystal display element; magnetic head elements; integrated circuit elements; solid-state image sensing elements; and mounted substrates. These electronic parts are, in general, provided with interlayer insulating films to be insulated between wirings arranged in layers, planarizing insulating films or insulating films for surface protection (e.g., over-coat films, passivation films), and the film can suitably be used as these insulating films.

The film can also be suitably used as, for example, a film for a light guide plate, a film for a polarizing plate, a film for a display, a film for an optical disc, a transparent conductive film, a film for a waveguide plate and a film for a printed circuit board.

<Insulating Film>

The resin composition of the present invention is suitably used for forming the insulating film.
The insulating film contains the polymer (I), and therefore is excellent in heat resistance, mechanical strength, electrical properties and the like in a balanced manner.
In particular, the insulating film is excellent in heat resistance and the like, as well as has low relative permittivity, and thereby can prevent the generation of condenser capacity (parasitic capacitance) between wirings accompanied by the densification of electronic parts such as semiconductor element, can prevent an increase in relative permittivity even when applied without modification to production processes of known electronic parts, and can be suitably used in a high-frequency circuit.
Examples in which the insulating film is used in a mounted (circuit) substrate include the mounted (circuit) substrates as shown in Figure 1 and Figure 2.
The mounted (circuit) substrate shown in Figure 1 can be obtained by, for example, forming a metal pad 2 on a substrate 1 in a patterned shape; and then forming an insulating film 3 in a patterned shape by using the resin composition; and then forming a metal wiring 4 in a patterned shape. The mounted (circuit) substrate as shown in Figure 2 can be obtained, for example, by forming an insulating film 5 on a metal wiring in the mounted substrate shown in Figure 1 using the additional resin composition.
Thickness of the insulating film may be appropriately selected depending on the desired application thereof, but is preferably from 0.05 to 100 μm, and more preferably from 0.5 to 50 μm.
Preferable values of Tg, tensile strength, elongation at break, tensile modulus of elasticity, coefficient of humidity expansion and refractive index of the insulating film are the same as preferable values of Tg, tensile strength, elongation at break, tensile modulus of elasticity, coefficient of humidity expansion and refractive index of the film.
A coefficient of linear expansion of the insulating film, measured using a SSC-5200 TMA measuring device (manufactured by Seiko Instruments), is preferably not more than 80 ppm/K and more preferably not more than 75 ppm/K.
The relative permittivity of the insulating film is preferably 2.0 to 4.0, more preferably 2.3 to 3.5, and even more preferably 2.5 to 3.2. The relative permittivity can be measured using a 4284A LCR meter, manufactured by HP Co., Ltd. When the relative permittivity is within the above ranges and when the insulating film is used in electronic part, signal transmission delays and an increase of power consumption caused by the generation of condenser capacity (parasitic capacitance) between wirings accompanied by the densification of electronic part such as semiconductor element can be prevented. Therefore, the insulating film can be suitably used particularly in a high-frequency circuit.
When the thickness of the insulating film is 30 μm, a total light transmittance in accordance with JIS K7105 transparency testing methods is preferably not less than 85% and more preferably not less than 88%. The total light transmittance can be measured using a haze meter, SC-3H, manufactured by Suga Test Instruments Co., Ltd.
When the thickness of the insulating film is 30 μm, a light transmittance at a wavelength of 400 nm is preferably not less than 70%, more preferably not less than 75%, and even more preferably not less than 80%. The light transmittance at a wavelength of 400 nm can be measured using an ultraviolet-visible spectrophotometer V-570 (manufactured by JASCO Corporation).
When the thickness of the insulating film is 30 μm, a YI value is preferably not greater than 3.0, more preferably not greater than 2.5, and even more preferably not greater than 2.0. The YI value can be measured using an SM-T color meter, manufactured by Suga Test Instruments Co., Ltd.
When the thickness of the insulating film is 30 μm, a YI value after heating for one hour at 230°C in air using a hot air dryer is preferably not greater than 3.0, more preferably not greater than 2.5, and even more preferably not greater than 2.0.

<Semiconductor Element>

The resin composition of the present invention can be suitably used for forming a semiconductor element.
Examples of the semiconductor element include an organic thin-film transistor and the like.
The semiconductor element can be produced by, for example, arranging or adhering the insulating film on the desired position or, alternatively, may be produced while forming the insulating film after applying the resin composition to the desired position.
The organic thin-film transistor preferably has, on a substrate, (a) an organic semiconductor film, (b) a gate electrode, (c) a source electrode, (d) a drain electrode and (e) a gate insulating film.
Examples of the substrate include, but not particularly limited to, for example, a flexible resin film composed of polycarbonate, polyimide, polyethylene terephthalate, alicyclic olefin polymer or the like; a glass substrate composed of quartz, soda glass, inorganic alkali glass or the like; and a silicon substrate such as a silicon wafer.
Example of the organic semiconductor material constituting (a) the organic semiconductor film include, but not particularly limited to, for example, a n-conjugated material. Examples of the n-conjugated material include, for example:

polypyrroles such as polypyrrole, poly (N- substituted pyrrole), poly (3- substituted pyrrole), and poly (3, 4- disubstituted pyrrole) ;
polythiophenes such as polythiophene, poly (3- substituted thiophene), poly (3, 4- disubstituted thiophene), and polybenzothiophene;
poly (p- phenylenevinylene) s such as poly (p- phenylenevinylene) ;
polyanilines such as polyaniline, poly (N- substituted aniline), poly (3- substituted aniline), and poly (2, 3- disubstituted aniline) ;
polyacetylenes such as polyacetylene, and polydiacetylene;
polypyrenes such as polypyrene;
poly (p- phenylene) s such as poly (p- phenylene) ;
polyacenes such as naphthacene, pentacene, and hexacene;
metallophthalocyanines such as copper phthalocyanine, and chlorine- or fluorine-substituted copper phthalocyanine;
carbon nanotubes such as single-walled carbon nanotube (SWNT); and
dyes such as merocyanine dye, hemicyanine dye.
Among these n-conjugated materials, polythiophenes, polyanilines, polyacetylenes, polyacenes, and metallophthalocyanines can be suitably used.

Process for forming the organic semiconductor film can be carried out by known methods, including, for example, vacuum evaporation, molecular beam epitaxy, ionized cluster beam method, low-energy ion beam method, ion plating, chemical vapor deposition (CVD), sputtering, plasma polymerization, electrolytic polymerization, chemical polymerization, spray coating, spin coating, blade-coating, dip-coating, cast method, roll coating, bar coating, die coating, and Langmuir-Blodgett (LB) method.
The film thickness of the organic semiconductor film is, preferably not more than 1 μm, and more preferably not less than the thickness of a single molecular layer and not more than 400 nm.
In the organic thin- film transistor, electrically conductive materials constituting (b) a gate electrode, (c) a source electrode and (d) a drain electrode include, for example, platinum, gold, silver, nickel, chromium, copper, iron, tin, antimony, lead, tantalum, indium, palladium, tellurium, rhenium, iridium, aluminum, ruthenium, germanium, molybdenum, tungsten, antimony tin oxide, indium tin oxide (ITO), fluorine- doped zinc oxide, zinc, carbon, graphite, glassy carbon, silver paste, carbon paste, beryllium, magnesium, calcium, scandium, titanium, manganese, zirconium, gallium, niobium, sodium- potassium alloy, magnesium/ copper mixture, magnesium/ silver mixture, magnesium/ aluminum mixture, magnesium/ indium mixture, aluminum/ aluminum oxide mixture, and lithium/ aluminum mixture.
Examples of process for forming an electrode include: a process for forming an electrode by using an application liquid such as solution, paste, ink, or dispersion liquid containing the electrically conductive material; a process in which an electrically conductive thin film is formed by using the electrically conductive material as a source of a method such as evaporation or sputtering, and then an electrode is formed from the electrically conductive thin film by photolithography, lift-off method, or metal-mask method; and a process in which a resist is formed on a metallic foil such as aluminum or copper by, for example, thermal transfer or ink jet, and then etching is carried out.
In particular, the electrode can be formed by applying a solution or a dispersion liquid of electrically conductive polymer, a dispersion liquid containing metallic fine particles or the like in a patterned shape directly by an ink jet process, or by forming a coating film from these solution or dispersion liquid and then patterning the coating film by lithography, laser ablation or the like. Furthermore, processes for patterning an electrically conductive ink, an electrically conductive paste or the like containing an electrically conductive polymer or a metallic fine particle by a printing method such as relief printing, intaglio printing, litho printing, or screen printing can be used.
The thickness of the electrode is, but not particularly limited to, preferably 20 nm to 500 nm and more preferably 50 nm to 200 nm.
As (e) the gate insulating film, the insulating film formed from the resin composition of the present invention is preferably used. The process for forming the gate insulating film can employ known processes, including processes in which the resin composition of the present invention is applied on a gate electrode by a wet process such as, for example, spray coating, spin coating, blade-coating, dip-coating, cast process, roll coating, bar-coating, or die-coating, and then dried. In the present invention, the film thickness of the gate insulating film is preferably 20 nm to 1 μm and more preferably 80 nm to 500 nm. By using the insulating film as a gate insulating film of the organic thin-film transistor, an organic thin-film transistor which has low electric current when turned off and has a high ON/OFF ratio can be produced.

<Display Element>

The resin composition of the present invention can be suitably used to form a display element. In particular, the resin composition can be used as a coat-type material for forming an organic insulating film in a thin-film transistor which is used for display driving. As the material for forming the organic insulating film, inorganic material such as silicon

nitride has been conventionally used. However, by using the resin composition of the present invention, the production the organic insulating film can be carried out with reduced production cost and capital investment, and with less energy due to not needing any vacuum devices to form a film. In addition, use of the resin composition of the present invention enables the formation of an organic insulating film at low temperature, and therefore can create more options for the substrate in a flexible display which uses a resin substrate as a substrate.

<Protective Film>

The resin composition of the present invention can be used as a material in a mounting process which uses a heat- resistance insulating material such as polyimide or polybenzoxazole. For example, the resin composition can be used as a material for forming a protective film when polyimide is used as a gate insulating film. The protective film is desired to be able to protect an element such as an electrode of an organic thin- film transistor containing a gate insulating film composed of a heat- resistance insulating material such as polyimide or polybenzoxazole, and to be able to be easily removed when the organic thin- film transistor is mounted. Properties required for protective films are basically similar to those of the insulating film, while properties required for resins are pyrolysis temperature comparable to polyimide and polybenzoxazole and solubility in a poor solvent for polyimide, polybenzoxazole or the like. Being soluble in the solvents, for example, it can be used as a protective film for the organic thin- film transistor containing a gate insulating film composed of a heat resistance insulating material such as polyimide, polybenzoxazole or the like. Examples of the poor solvent of polyimide preferably include cyclohexanone, γ- butyrolactone, 1- methoxy- 2- propyl acetate, N-methylpyrrolidone, N, N- dimethylacetamide, 3- methoxy- N, N- dimethylpropionamide, and 3- n- butoxy- N, N- dimethylpropionamide.

«Electronic Part»

Electronic parts of the present invention have the film and/or the insulating film. Examples of the electronic part include semiconductor element; display element such as thin-film transistor-liquid crystal display element; magnetic head element; integrated circuit element; solid-state image sensing element; and mounted substrate. These electronic parts are, in general, provided with an interlayer insulating film for insulating between wirings arranged in layers, a planarizing insulating film or an insulating film for surface protection (e.g., over-coat film, passivation film), and the film described above can suitably be used as these insulating films. The film can also be used as a protective film when these electronic parts are produced.

**Examples**

Hereinafter, the present invention is specifically described by way of Examples.

(1-1) Weight average molecular weight (Mw) and number average molecular weight (Mn)

The weight average molecular weight (Mw) and number average molecular weight (Mn) of each polymer obtained in the following Examples of Synthesis were measured using a HLC-8220 GPC apparatus manufactured by Tosoh Corporation (column: TSK gel α-M; developing solvent: THF).

(1-2) Glass transition temperature (Tg)

The glass transition temperature (glass transition point) of each evaluation film obtained in the following Examples 1-1 to 1-9 and Comparative Examples 1-1 to 1-2 was measured at a heating rate of 20°C/min by using a 8230 DSC measuring apparatus manufactured by Rigaku Corporation.

(1-3) Optical Properties

Total light transmittance (Tt) and haze value were measured for each evaluation film obtained in the following Examples 1-1 to 1-9 and Comparative Examples 1-1 to 1-2 in accordance with JIS K7105 transparency testing methods. Specifically, they were measured using a SC-3H haze meter manufactured by Suga Test Instruments Co., Ltd. Results of the measurements are shown in Table 1.

(1-4) Appearance and the like

- "Roughness" and "turbidity" were evaluated from the values of total light transmittance and haze.
- "Cissing" was evaluated by visual observation of interference fringes on the surface of a film as one of the appearances and by quantitative evaluation of film thickness (deviation of film thickness) using the formula described below. The film shall pass an inspection when the deviation of film thickness is not more than 3%. Results of the evaluation are shown in Table 1.

(the maximum film thickness in a ten-point measurement - the minimum film thickness in the ten-point measurement) x 100 / (the average of the ten-point measurement)

In the ten-point measurement, the 10 measurement points at equal intervals were defined on the long axis of each evaluation film obtained in the following Examples 1-1 to 1-9 and Comparative Examples 1-1 to 1-2 and the film thickness was measured using a DEKTAK 3 profiler (manufactured by Veeco Instruments Inc.).

In the present invention, "cissing" refers to a situation where a composition has a poor wetting property to a substrate. In cases where a composition having a poor wetting property to a substrate is used, when the composition is applied on the substrate to produce a film, a film having a large deviation in thickness, i.e., a film with poor surface flatness, is obtained. Because of this, in the present invention, "deviation of film thickness" was used as an evaluation criterion for "cissing".

- "Residual solvent" was evaluated by thermogravimetric analysis, TG/DTA. Each evaluation film obtained in the following Examples 1-1 to 1-9 and Comparative Examples 1-1 to 1-2 was heated from 25°C to 350°C at a heating rate of 10°C /min and the weight lost during the heating was intended to be the amount of residual solvent. A TG-8120 TG-DTA measuring apparatus manufactured by Rigaku Corporation was employed for the evaluation. Results of the evaluation are shown in Table 1.

- "Lower limit of film thickness" was evaluated as follows: each of the compositions for thin-film production, which compositions were obtained in the following Examples 1-1 to 1-8, was applied on a silicon wafer by spin coating and dried at 70°C for 30 min and then 100°C for 30 min to obtain a film with a film thickness as close as possible to a target lower limit of 1 μm; the thickness of the film was measured in accordance with the same method as in the above-described evaluation of cissing; when the deviation of film thickness was within ±2%, the thickness of the film was defined as the lower limit of the film. The smaller value of the lower limit of film thickness for a composition represents the greater possibility for the composition to form a thin film having uniform film properties.

(Example of Synthesis 1)

To a 2 L four- neck flask, 72.51 g of 4, 4'- dichlorodiphenyl sulfone (hereinafter also referred to as "DCDPS") (0.2525 mol), 70.08 g of 9, 9- bis (4- hydroxyphenyl) fluorene (hereinafter also referred to as "BPFL") (0.2000 mol), 16.81g of 2, 2- bis (4- hydroxyphenyl)- 1, 1, 1, 3, 3, 3- hexafluoropropane (0.0500 mol), 41.46 g of potassium carbonate (0.3000 mol), 640 g of N, N- dimethylacetamide (hereinafter also referred to as "DMAc") and 160 g of toluene were added. Then, a thermometer, a stirrer, a three- way cock with a nitrogen introduction tube, a Dean- Stark tube and a cooling tube were attached to the four- neck flask.

Next, the flask was purged with nitrogen, and then the resultant solution was allowed to react at 140°C for 3 hours with removing the generated water continuously through the Dean- Stark tube. After no water generation was detected, the temperature was raised gradually to 160°C and the solution was allowed to react at the temperature for 5 hours.

After the solution was cooled to room temperature (25°C), the generated salt was removed with filter paper and the filtrate was poured into methanol to reprecipitate. The solution was subjected to filtration to isolate cake (residue) . The resultant cake was vacuum dried at 60°C overnight to obtain a white powder (polymer) (amount yielded: 133 g, yield: 94%) . The weight average molecular weight of the obtained polymer was 97, 000 and its number average molecular weight was 32, 000.

(Example of Synthesis 2)

The same operation was performed as in Example of Synthesis 1 to obtain a target polymer, except that 35.12 g of 2,6-difluorobenzonitrile (hereinafter also referred to as "DFBN") (0.2525 mol) was used instead of DCDPS. The weight average molecular weight of the obtained polymer was 85, 000 and its number average molecular weight was 30,000.

(Example of Synthesis 3)

The same operation was performed as in Example of Synthesis 2 to obtain a target polymer, except that 85.15 g of 9, 9- bis (3- methyl- 4- hydroxyphenyl) fluorene (0.2250 mol) and 4.66 g of 4, 4'- biphenol (0.0250 mol) were used instead of BPFL and 2, 2- bis (4- hydroxyphenyl)- 1, 1, 1, 3, 3, 3- hexafluoropropane. The weight average molecular weight of the obtained polymer was 89, 000 and its number average molecular weight was 30, 000.

[Example 1-1]

The polymer obtained in Example of Synthesis 1 was dissolved in an organic solvent containing N- methyl- 2-pyrrolidone (hereinafter also referred to as "NMP") and methyl ethyl ketone (hereinafter also referred to as "MEK") at a weight ratio of 70: 30 to obtain a resin composition having a polymer concentration of 7.5% by mass and a composition for thin- film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm. The glass transition temperature of the evaluation film was 250°C.

[Example 1-2]

The polymer obtained in Example of Synthesis 1 was dissolved in an organic solvent containing NMP and cyclohexanone (hereinafter also referred to as "CHN") at a weight ratio of 70:30 to obtain a resin composition having a polymer concentration of 7.5% by mass and a composition for thin-film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Example 1-3]

The polymer obtained in Example of Synthesis 1 was dissolved in an organic solvent containing NMP and CHN at a weight ratio of 50:50 to obtain a resin composition having a polymer concentration of 10% by mass and a composition for thin-film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Example 1-4]

The polymer obtained in Example of Synthesis 1 was dissolved in an organic solvent containing NMP and γ-butylolactone (hereinafter also referred to as "g-BL") at a weight ratio of 70:30 to obtain a resin composition having a polymer concentration of 7.5% by mass and a composition for thin-film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Example 1-5]

The polymer obtained in Example of Synthesis 2 was dissolved in an organic solvent containing NMP and CHN at a weight ratio of 50:50 to obtain a resin composition having a polymer concentration of 7.5% by mass and a composition

for thin-film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm. The glass transition point of the evaluation film was 285°C.

[Example 1-6]

The polymer obtained in Example of Synthesis 3 was dissolved in an organic solvent containing NMP and CHN at a weight ratio of 50:50 to obtain a resin composition having a polymer concentration of 7.5% by mass and a composition for thin-film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm. The glass transition point of the evaluation film was 251°C.

[Example 1-7]

The polymer obtained in Example of Synthesis 3 was dissolved in an organic solvent containing NMP and anisole at a weight ratio of 50:50 to obtain a resin composition having a polymer concentration of 7.5% by mass and a composition for thin-film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Example 1-8]

The polymer obtained in Example of Synthesis 3 was dissolved in NMP to obtain a composition for film production having a polymer concentration of 7.5% by mass and a composition for thin-film production having a polymer concentration of 5% by mass. The obtained resin composition was applied on a silicon wafer by using a spin coater and dried at 70°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Example 1-9]

The polymer obtained in Example of Synthesis 3 was dissolved in THF to obtain a resin composition having a polymer concentration of 7.5% by mass. The composition was applied on a silicon wafer by using a spin coater and dried at 30°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Comparative Example 1-1]

The polymer obtained in Example of Synthesis 3 was dissolved in methylene chloride (hereinafter also referred to as "DCM") to obtain a composition for film production having a polymer concentration of 7.5% by mass. The composition was applied on a silicon wafer by using a spin coater and dried at 30°C for 30 min and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Comparative Example 1-2]

The polymer obtained in Example of Synthesis 3 was dissolved in DCM to obtain a composition for film production having a polymer concentration of 7.5% by mass. The composition was applied on a silicon wafer by using a spin coater and dried at 30°C for 24 hours and then at 100°C for 30 min to produce a film, which was subsequently delaminated from the silicon wafer. Thereafter, the film was held in a metal frame and dried further at 230°C for 2 hours to obtain an evaluation film with a film thickness of 20 μm.

[Table 1]

| | Resin | Solvent Species | Solvent Mixture Ratio | Primary drying condition | Tt [%] | Haze | Deviation of Film Thickness [%] | Residual Solvent [%] | Lower Limit of Film Thickness [μm] |
|---|---|---|---|---|---|---|---|---|---|
| Example 1-1 | 1 | NMP/MEK | 70/30 | 70°C/30 min | 88 | 1.3 | 1.8 | 0.2 | 3 |
| Example 1-2 | 1 | NMP/CHN | 70/30 | | 88 | 1.0 | 1.3 | 0.3 | 1 |
| Example 1-3 | 1 | NMP/CHN | 50/50 | | 88 | 0.9 | 1.2 | 0.2 | 1 |
| Example 1-4 | 1 | NMP/g-BL | 70/30 | | 88 | 1.4 | 1.9 | 0.5 | 5 |
| Example 1-5 | 2 | NMP/CHN | 50/50 | | 88 | 0.9 | 1.4 | 0.3 | 1 |
| Example 1-6 | 3 | NMP/CHN | 50/50 | | 88 | 0.8 | 1.1 | 0.4 | 1 |
| Example 1-7 | 3 | NMP/ Anisole | 50/50 | | 88 | 0.8 | 1.0 | 0.3 | 1 |
| Example 1-8 | 3 | NMP | 100 | | 88 | 1.4 | 2.3 | 0.4 | 15 |
| Example 1-9 | 3 | THF | 100 | 30°C/30 min | 88 | 1.2 | 2.9 | 0.2 | - |
| Comparative Example 1-1 | 3 | DCM | 100 | | 86 | 2.8 | 8.8 | 0.2 | - |
| Comparative Example 1-2 | 3 | DCM | 100 | 30°C/24 h | 87 | 1.9 | 5.3 | 0.2 | - |

It is clear that the haze value and the deviation of film thickness are small in the films prepared from the compositions containing at least one kind of organic solvent selected from the group consisting of ether solvents, ketone solvents, ester solvent and amide solvent. Also, it is clear that the haze value and the deviation of film thickness are particularly small in the films prepared from the compositions containing cyclic ketone solvents and amide solvents or containing ether solvents and amide solvents.
Moreover, the films obtained by using solvent mixtures, especially the solvent mixtures of NMP and cyclohexanone, had superior uniformity, while it was difficult to produce a thin film from the composition, which was prepared by using NMP alone as a solvent, since the composition easily repels a substrate.

(2-1) Structure analysis

The structure analysis of each polymer obtained in the following Examples and Comparative Examples was performed by IR (ATR method, FT-IR, 6700, manufactured by NICOLET).

(2-2) Weight average molecular weight (Mw), number average molecular weight (Mn), and molecular weight distribution (Mw/Mn)

The weight average molecular weight (Mw), number average molecular weight (Mn), and molecular weight distribution (Mw/Mn) of each polymer obtained in the following Examples and Comparative Examples were measured using a HLC-8220 GPC apparatus manufactured by Tosoh Corporation (column: TSK gel α-M; developing solvent: THF).

(2-3) Glass transition temperature (Tg)

The glass transition temperature of each of the polymers or films obtained in the following Examples and Comparative Examples was measured at a heating rate of 20°C/min by using a 8230 DSC measuring apparatus manufactured by Rigaku Corporation.

(2-3') Pyrolysis temperature

The pyrolysis temperature of each polymer obtained in the following Examples and Comparative Examples was measured by thermogravimetric analysis (TGA; performed under a nitrogen atmosphere, heating rate: 10°C/min,

5% weight loss temperature).

(2-4) Mechanical strength

Tensile strength, elongation at break, and tensile modulus of elasticity at room temperature were measured for the films obtained in the following Examples and Comparative Examples using a tensile tester 5543 (manufactured by INSTRON Inc.) in accordance with JIS K7127.

(2-5) Environmental stability

The coefficient of linear expansion of each film obtained in the following Examples and Comparative Examples was measured using a SSC-5200 TMA measurement device manufactured by Seiko Instruments Inc. After increasing the temperature to a temperature 20°C below Tg, the coefficient of linear expansion was calculated from the slope between 200 to 100°C when lowering the temperature at a rate of 3°C/min.

Measurement of coefficient of humidity expansion was performed for the films obtained in the following Examples and Comparative Examples by using MA (TMA- SS6100, manufactured by SII Nano Technology Inc.) with humidity control option under the following conditions.

Humidity conditions: humidity was changed every 10% RH from 40% RH to 70% RH (stretching method: added load of 5 g) ; temperature: 23°C

(2-6) Relative permittivity

The relative permittivity of each film obtained in the following Examples and Comparative Examples was measured using 4284A LCR meter manufactured by HP Ltd. A measurement condition was as follows: frequency, 100 MHz; atmosphere, at room temperature under atmosphere; electrode, electrode of a diameter of 5 mm with aluminum deposited (with a guard electrode).

(2-7) Coefficient of water absorption

Three pieces of films in a size of 3 cm x 4 cm were cut from each film obtained in the following Examples and Comparative Examples and were vacuum dried at 180°C for 8 hours. The mass of the pieces of each film was measured, and then they were immersed in distilled water at 25°C for 24 hours. Water drops on the surface of the pieces of each film were wiped out after the immersion, and the coefficient of water absorption (%) of each film was calculated from the change in the mass of the pieces between before and after the immersion.

(2-8) Optical properties

Total light transmittance and yellow index (YI) value were measured for each film obtained in the following Examples and Comparative Examples in accordance with JIS K7105 transparency testing methods. Specifically, the total light transmittance and the YI value (YI before heating) of each film were measured using a SC-3H haze meter manufactured by Suga Test Instruments Co., Ltd. and using a SM-T color meter manufactured by Suga Test Instruments Co., Ltd., respectively.

After heating the films obtained in the following Examples and Comparative Examples with a hot air drier under atmosphere at 230°C for 1 hour, YI value was measured for each of the films using a color meter, SM-T, manufactured by Suga Test Instruments Co., Ltd. (YI after heating). The measurement was performed in accordance with JIS K7105 condition.

Light transmittance was measured at a wavelength of 400 nm for each of the films obtained in the following Examples and Comparative Examples by using a ultraviolet-visible spectrophotometer V-570 (manufactured by JASCO Corporation), and the refractive index of each of the obtained films was measured using a prism coupler model 2010 (manufactured by Metricon Corporation) . The refractive index was measured using a wavelength of 633 nm.

(2-9) Solubility in g-BL

In order to use it as an index to be considered when any of the films obtained in Examples and Comparative Examples is employed as a protective film, the solubility of the films to a poor solvent for polyimide, g-BL, was evaluated as described below.

The films obtained in the Examples and Comparative Examples were immersed in g-BL at 80°C for 1 hour. "○" and "×" were intended to represent films which had been completely dissolved in g-BL and films which had not been dissolved

or had remained to be completely dissolved in g-BL, respectively.

(2-10) Film surface uniformity

Surface uniformity was evaluated for each of the films and the test films to be analyzed by surface measurement obtained in Examples 2-1 to 2-4 by comparing their Ra values (nm). The evaluation was performed in accordance with JIS B 0601.

[Example 2-1]

<Synthesis of a polymer>

To a 3 L four- neck flask, Component (A) : 35.12 g of 2, 6- difluorobenzonitrile (hereinafter also referred to as "DFBN") (0.253 mol) ; Component (B) : 70.08 g of 9, 9- bis (4- hydroxyphenyl) fluorene (hereinafter also referred to as "BPFL") (0.200 mol), 5.51 g of resorcinol (hereinafter also referred to as "RES") (0.050 mol) ; 41.46 g of potassium carbonate (0.300 mol), 443 g of N, N- dimethylacetamide (hereinafter also referred to as "DMAc") and 111 g of toluene were added. Then, a thermometer, a stirrer, a three- way cock with a nitrogen introduction tube, a Dean- Stark tube and a cooling tube were attached to the four- neck flask.

Next, the flask was purged with nitrogen, and then the resultant solution was allowed to react at 140°C for 3 hours with removing the generated water continuously through the Dean- Stark tube. After no water generation was detected, the temperature was raised gradually to 160°C and the solution was allowed to react at the temperature for 6 hours.

After the solution was cooled to room temperature (25°C), the generated salt was removed with filter paper and the filtrate was poured into methanol to reprecipitate. The solution was subjected to filtration to isolate cake (residue) . The resultant cake was vacuum dried at 60°C overnight to obtain a white powder (polymer) (amount yielded: 95.67 g, yield: 95%) .

The physical properties of the obtained polymer are shown in Table 2. Structure analysis and measurement of weight average molecular weight were performed for the obtained polymer. The results were as follows: the characteristic absorption of the infrared absorption spectrum was at 3035 $cm^{-1}$ (C-H stretch), 2229 $cm^{-1}$ (CN), 1574 $cm^{-1}$, 1499 $cm^{-1}$ (aromatic ring skeleton absorption), 1240 $cm^{-1}$ 1 (-o-) ; and the weight average molecular weight was 130,000.

<Film>

Next, the obtained polymer was redissolved in DMAc to gain a resin composition having a polymer concentration of 20% by mass. The resin composition was applied on a substrate made of polyethylene terephthalate (PET) using a doctor blade and dried at 70°C for 30 min and then 100°C for 30 min to gain a coating film, which was subsequently delaminated from the PET substrate. Thereafter, the coating film was held in a metal frame and dried further at 230°C for 2 hours to obtain a film with a film thickness of 30 μm.

The physical properties of the obtained film are shown in Table 2.

Furthermore, a test film with a film thickness of 30 μm to be analyzed by surface measurement was prepared in the same method as described in the above- described paragraph <Film>, except that the obtained polymer was redissolved in a solvent mixture containing DMAc and CHN at a weight ratio of 70: 30 instead of being redissolved in DMAc.

<Production of an organic thin-film transistor>

The obtained polymer was redissolved in DMAc to gain a resin composition having a polymer concentration of 5% by mass. An aluminum film was deposited on a glass substrate (2 cm x 2 cm x 1 mm) at room temperature under a vacuum condition (not more than 1 x $10^{-2}$ Pa) to produce a gate electrode with a film thickness of 0.2 μm. The resin composition was applied by using a spin coater at a rotation speed of 3,000 ppm for 30 seconds on the substrate on which the gate electrode had been prepared, and was heated at 230°C under nitrogen for 30 min after evaporation of the solvent to produce a gate insulating film with a film thickness of about 200 nm.

Pentacene was deposited on this gate insulating film under the following conditions to produce an organic semiconductor film with a film thickness of about 50 nm: degree of vacuum, less than 1 x $10^{-2}$ Pa; substrate temperature, room temperature; deposition temperature, 180°C; deposition speed, 0.05 nm/sec. This organic semiconductor film was covered with a metal mask and gold was deposited onto it under the following conditions to produce a source electrode and a drain electrode (5 mm wide (W), 20-70 μm long (L)), both of which have a film thickness of about 200 nm, and to obtain an organic thin-film transistor in a bottom gate configuration: degree of vacuum, less than 1 x $10^{-2}$ Pa; substrate temperature, room temperature.

Electrical properties were evaluated for the obtained organic thin-film transistor. The physical properties of the obtained organic thin-film transistor are shown in Table 2. The electrical properties were evaluated using a semiconductor tester (R6425, Advantest Corporation). For the switch-off current of an organic thin-film transistor, "○" and "×" were intended to represent a current less than $1.0 \times 19^{-9}$ A/cm$^2$ and a current equal to or more than $1.0 \times 10^{-9}$ A/cm$^2$, respectively. For the ON/OFF ratio of an organic thin-film transistor, "×" and "○" were intended to represent a ratio less than $10^4$ and a ratio equal to or more than $10^4$, respectively.

[Example 2-2]

The same operation was performed as in Example 2- 1, except that 11.41 g of 2, 2- bis (4- hydroxyphenyl) propane (0.050 mol) was used instead of RES. The physical properties of the obtained polymer, film, test film to be analyzed by surface measurement and organic thin- film transistor are shown in Table 2.

[Example 2-3]

The same operation was performed as in Example 2- 1, except that 78.84 g of BPFL (0.225 mol) and 8.41 g of 2, 2- bis (4- hydroxyphenyl)- 1, 1, 1, 3, 3, 3- hexafluoropropane (0.025 mol) were used as Component (B) instead of 70.08 g of BPFL and 5.51 g of RES. The physical properties of the obtained polymer, film, test film to be analyzed by surface measurement and organic thin- film transistor are shown in Table 2.

[Example 2-4]

The same operation was performed as in Example 2- 1, except that 125.65 g of 9, 9- bis (3- phenyl- 4- hydroxyphenyl) fluorene (0.250 mol) was used as Component (B) instead of 70.08 g of BPFL and 5.51 g of RES. The physical properties of the obtained polymer, film, test film to be analyzed by surface measurement and organic thin- film transistor are shown in Table 2.

[Example 2-5]

The same operation was performed as in Example 2-1, except that 87.60 g of BPFL (0.250 mol) was used as Component (B) instead of 70.08 g of BPFL and 5.51 g of RES. The physical properties of the obtained polymer, film and organic thin-film transistor are shown in Table 2.

[Example 2-6]

The same operation was performed as in Example 2- 1, except that 78.84 g of BPFL (0.225 mol) and 6.71 g of 1, 1- bis (4- hydroxyphenyl) cyclohexane (0.025 mol) were used as Component (B) instead of 70.08 g of BPFL and 5.51 g of RES. The physical properties of the obtained polymer, film and organic thin- film transistor are shown in Table 2.

[Example 2-7]

The same operation was performed as in Example 2-5, except that 28.10 g of DFBN (0.202 mol) and 11.02 g of 4, 4'-difluorobenzophenone (0.051 mol) were used as Component (A) instead of 35.12 g of DFBN. The physical properties of the obtained polymer, film and organic thin-film transistor are shown in Table 2.

[Example 2-8]

The same operation was performed as in Example 2-7, except that the amount of Component (A) were changed to 17.56 g of DFBN (0.126 mol) and 27.55 g of 4,4'-difluorobenzophenone (0.126 mol). The physical properties of the obtained polymer, film and organic thin-film transistor are shown in Table 2.

[Example 2-9]

The same operation was performed as in Example 2-5, except that 63.56 g of 4,4'-difluorodiphenylsulfone (DFDS) (0.250 mol) was used as Component (A) instead of 35.12 g of DFBN. The physical properties of the obtained polymer, film and organic thin-film transistor are shown in Table 2.

[Comparative Example 2-1]

The same operation was performed as in Example 2- 1, except that 84.06 g of 2, 2- bis (4- hydroxyphenyl)- 1, 1, 1, 3, 3, 3- hexafluoropropane (0.250 mol) was used as Component (B) instead of 70.08 g of BPFL and 5.51 g of RES. The physical properties of the obtained polymer and film are shown in Table 2.

[Comparative Example 2-2]

An evaluation was performed by using a polyethylene naphthalate film (with a film thickness of 125 μm) manufactured by TEIJIN Ltd., Teonex, in accordance with the same methods as in Example 2-1. The physical properties of the film are shown in Table 2.

[Comparative Example 2-3]

To a 300 mL four- neck flask, which was equipped with a thermometer, a stirrer, a nitrogen introduction tube and a cooling tube, 9.70 g of 2, 2- bis [4- (4- aminophenoxy) phenyl] propane (23.6 mmol) was added. Next, the flask was purged with nitrogen, and then N- methyl- 2- pyrrolidone (NMP) (60 mL) was added to the flask and was stirred until homogeneous. To the resultant solution, 5.30 g of 2, 3, 5- tricarboxycyclopentyl acetic dianhydride (23.6 mmol) was added at room temperature and was allowed to react with stirring at the temperature for 12 hours to obtain a solution containing polyamic acid.

NMP (75 mL) was added to the obtained solution containing polyamic acid to dilute it and then pyridine (7.5 mL) and acetic anhydride (6.7 mL) were added and stirred at 110°C for 6 hours to perform imidization. After cooling to room temperature, then the solution was poured into a large volume of methanol and the obtained solution was subjected to filtration to isolate cake. The resultant cake was vacuum dried at 60°C overnight to obtain a white powder (polymer) (amount yielded: 13.5 g, yield: 95.3%).

Next, the obtained polymer was redissolved in DMAc to gain a 20% by mass resin solution. The resin solution was applied on a PET substrate by using a doctor blade (with a gap of 100 μm) and dried at 100°C for 30 min and then at 150°C for 60 min to produce a film, which was subsequently delaminated from the PET substrate. Thereafter, the film was dried further at 150°C under reduced pressure for 3 hours to obtain a film with a film thickness of 30 μm. An evaluation was performed in accordance with the same methods as in Example 2- 1. The result is shown in Table 2.

[Table 2]

Table 2A

| | Fundamental Properties | | | | | Optical Properties | | | Appearance | | Mechanical Strength | | |
|---|---|---|---|---|---|---|---|---|---|---|---|---|---|
| | Mw [-] | Mn [-] | Mw/M n [-] | Tg [°C ] | Pyrolysis Temperatur e [°C] | Light Transmittance / 400 nm [%] | Total Light Transmittanc e [%] | Refractiv e Index [-] | YI before Heatin g [-] | YI after Heatin g [-] | Tensile Strength [MPa] | Elongatio n at Break [%] | Tensile Modulus of Elasticit y [GPa] |
| Example 2-1 | 130,0 00 | - | - | 270 | 501 | 85 | 88 | 1.64 | 1.58 | 1.64 | 109 | 30 | 2.9 |
| Example 2-2 | 98,00 0 | 45,00 0 | 2.18 | 250 | 510 | 88 | 89 | 1.60 | 2.02 | 2.11 | 121 | 43 | 3 |
| Example 2-3 | 105,0 00 | 53,00 0 | 1.98 | 252 | 530 | 85 | 88 | 1.65 | 1.84 | 2.24 | 115 | 20 | 3.1 |
| Example 2-4 | 146,0 00 | 67,00 0 | 2.18 | 275 | 556 | 86 | 88 | 1.70 | 1.75 | 1.76 | 125 | 8 | 3.2 |
| Example 2-5 | 188,0 00 | 75,00 0 | 2.51 | 285 | 554 | 85 | 88 | 1.66 | 1.69 | 1.76 | 127 | 10 | 3.2 |
| Example 2-6 | 78,00 0 | 36,00 0 | 2.17 | 260 | 522 | 85 | 88 | 1.66 | 1.88 | 1.99 | 115 | 28 | 3.1 |
| Example 2-7 | 122,0 00 | - | - | 271 | 502 | 86 | 88 | 1.64 | 2.01 | 2.33 | 126 | 51 | 3.1 |
| Example 2-8 | 157, 0 00 | 42,00 0 | 3.74 | 250 | 500 | 86 | 88 | 1.65 | 1.79 | 1.94 | 120 | 56 | 3.2 |
| Example 2-9 | 132,0 00 | 37,00 0 | 3.57 | 265 | 524 | 86 | 88 | 1.70 | 1.81 | 1.92 | 125 | 22 | 3 |
| Comparative Example 2-1 | 180,0 00 | 72,00 0 | 2.50 | 185 | 514 | 88 | 92 | 1.56 | 1.24 | Melted | 109 | 82 | 2.8 |
| Comparative Example 2-2 | - | - | - | 155 | - | 76 | 87 | 1.66 | 1.54 | Melted | Not Fracture d | Not Fractured | 4.7 |
| Comparative Example 2-3 | 29200 0 | - | - | 280 | 447 | 86 | 90 | 1.60 | 0.8 | 3.53 | 136 | 109 | 2.6 |

Table 2B

| | Environmental Stability | | | Electrical Properties | | | | Film Surface Uniformity [Ra] | |
|---|---|---|---|---|---|---|---|---|---|
| | Coefficient of Linear Expansion [ppm/%RH] | Coefficient of Humidity Expansion [ppm/K] | Water Absorption [%] | Dielectric Constant | Switch-off Current [A/cm$^2$] | ON/OFF Ratio | Solubility in g-BL | Film [nm] | Test Film to be Analyzed by Surface Measurement [nm] |
| Example 2-1 | 63 | 10 | 0.5 | 2.9 | ○ | ○ | ○ | 13 | 5 |
| Example 2-2 | 57 | 8 | 0.5 | 2.9 | ○ | ○ | ○ | 11 | 5 |
| Example 2-3 | 58 | 8 | 0.5 | 2.9 | ○ | ○ | ○ | 12 | 7 |
| Example 2-4 | 71 | 6 | 0.5 | 2.8 | ○ | ○ | ○ | 16 | 6 |
| Example 2-5 | 60 | 6 | 0.5 | 2.8 | ○ | ○ | ○ | - | - |
| Example 2-6 | 65 | 6 | 0.5 | 2.8 | ○ | ○ | - | - | - |
| Example 2-7 | 58 | 7 | 0.5 | 3.0 | ○ | ○ | ○ | - | - |
| Example 2-8 | 55 | 7 | 0.5 | 3.1 | ○ | ○ | - | - | - |
| Example 2-9 | 56 | 6 | 0.5 | 3.1 | ○ | ○ | - | - | - |
| Comparative Example 2-1 | 63 | 7 | 0.5 | 2.8 | - | - | ○ | - | - |
| Comparative Example 2-2 | 20 | 10 | 0.5 | 3.1 | - | - | × | - | - |
| Comparative Example 2-3 | 57 | 99 | 1.7 | 3.4 | - | - | × | - | - |

From the results described above, it is clear that the insulating films prepared from the resin compositions of the present invention have superior heat resistance and electrical properties. Also, it is clear that the films produced from the compositions containing a solvent mixture have higher film surface uniformity. These allow the resin compositions of the present invention to be preferably used for production of insulating film, used for semiconductor elements, used for production of gate insulating film and used for resin compositions for display elements. Since, in addition to these properties, the resin compositions of the present invention have superior solubility to a poor solvent for polyimide, g-BL, they are preferably employed as a resin composition used for a protective film of an organic thin-film transistor having a gate insulating film composed of polyimide.

[EXPLANATION OF SYMBOLS]

1: Substrate
2: Metal pad
3: Insulating film
4: Metal wiring
5: Insulating film

## Claims

**1.** A resin composition comprising a polymer that comprises at least one structural unit (i) selected from the group consisting of structural units represented by the following formula (1) and structural units represented by the following formula (2); and at least one kind of organic solvent selected from the group consisting of ether solvents, ketone solvents, ester solvents and amide solvents:

[Chem. 1]

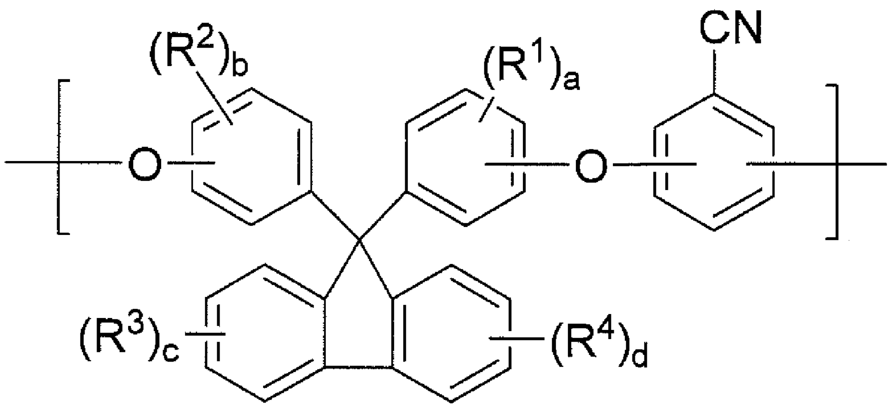

(1)

wherein in the formula (1), $R^1$ to $R^4$ are each independently a monovalent organic group having 1 to 12 carbon atoms; and "a" to "d" are each independently an integer of from 0 to 4,

[Chem. 2]

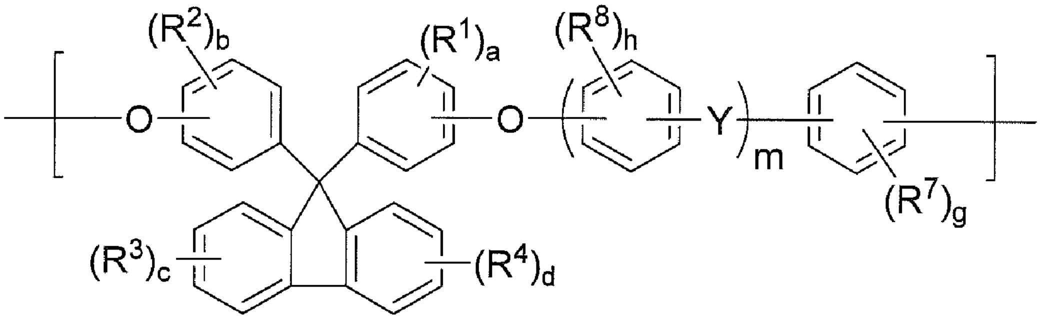

(2)

wherein in the formula (2), $R^1$ to $R^4$ and "a" to "d" are each independently defined in the same manner as described for $R^1$ to $R^4$ and "a" to "d" of the formula (1); Y is a single bond, $-SO_2$-or >C=O; $R^7$ and $R^8$ are each independently a halogen atom, a monovalent organic group having 1 to 12 carbon atoms or a nitro group; "g" and "h" are each independently an integer of from 0 to 4; and "m" is 0 or 1, provided that when m is 0, $R^7$ is not a cyano group.

2. The resin composition according to claim 1, wherein the organic solvent comprises at least one kind of organic solvent selected from the group consisting of ketone solvents, ester solvents and ether solvents; and an amide solvent.

3. The resin composition according to claim 1 or 2, wherein the ketone solvents are ketones having not less than 4 and not more than 10 carbon atoms.

4. The resin composition according to any one of claims 1 to 3, wherein the ester solvents are esters having not less than 3 and not more than 10 carbon atoms.

5. The resin composition according to any one of claims 1 to 4, wherein the ether solvents are ethers having not less than 3 and not more than 10 carbon atoms.

6. The resin composition according to any one of claims 1 to 5, wherein the amide solvents are amides having not less than 3 and not more than 10 carbon atoms.

7. The resin composition according to any one of claims 1 to 6, wherein the organic solvent comprises 5 to 95 parts by mass of the amide solvent based on 100 parts by mass of the total organic solvents.

8. The resin composition according to any one of claims 1 to 7, wherein the polymer concentration in the resin composition is 3 to 40% by mass.

9. The resin composition according to any one of claims 1 to 8, wherein the polymer further comprises at least one structural unit (ii) selected from the group consisting of structural units represented by the following formula (3) and structural units represented by the following formula (4).

[Chem. 3]

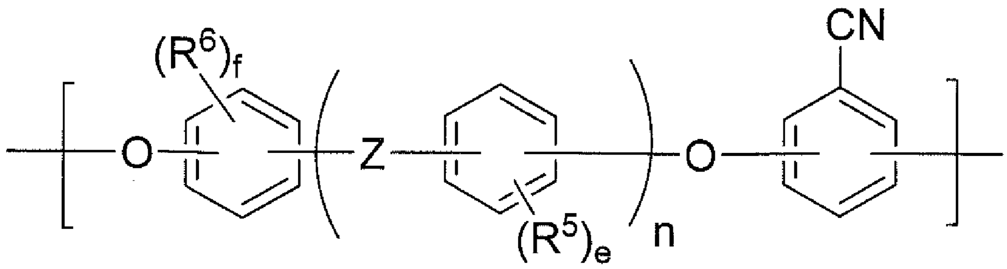

(3)

wherein in the formula (3), $R^5$ and $R^6$ are each independently a monovalent organic group having 1 to 12 carbon atoms; Z is a single bond, -O-, -S-, $-SO_2-$, >C=O, -CONH-, -COO- or a divalent organic group having 1 to 12 carbon atoms; "e" and "f" are each independently an integer of from 0 to 4; and "n" is 0 or 1,

[Chem. 4]

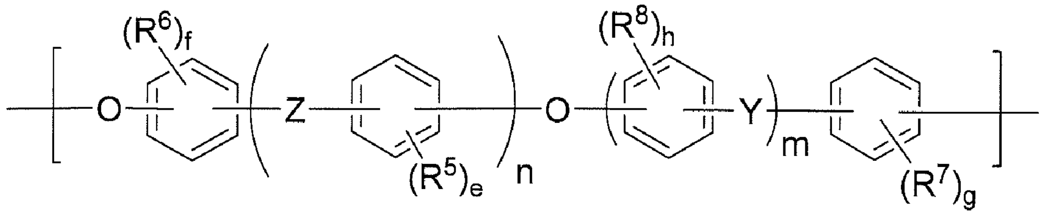

(4)

wherein in the formula (4), $R^7$, $R^8$, Y, "m", "g" and "h" are each independently defined in the same manner as described for $R^7$,$R^8$, Y, "m", "g" and "h" of the formula (2), and $R^5$, $R^6$, Z, "n", "e" and "f" are each independently defined in the same manner as described for $R^5$ $R^6$ Z, "n" "e" and "f" in the formula (3).

**10.** The resin composition according to claim 9, wherein the molar ratio of the structural unit (i) to the structural unit (ii) in the polymer is 50:50 to 100:0.

**11.** The resin composition according to any one of claims 1 to 10, wherein the polymer has a weight average molecular weight in terms of polystyrene measured by gel permeation chromatography (GPC) of 5,000 to 500,000.

**12.** The resin composition according to any one of claims 1 to 11, which is used for at least one use selected from the group consisting of use for forming an insulating film, use for a semiconductor element, use for a display element and use for forming a protective film.

**13.** An insulating film obtained from the resin composition according to any one of claims 1 to 11.

**14.** A process for forming a film, comprising the steps of applying the resin composition according to any one of claims 1 to 12 on a substrate to form a coating film, and removing the organic solvent from the coating film to provide a film.

**15.** An electronic part comprising the insulating film according to claim 13, or the film obtained by the process for forming a film according to claim 14.

Fig.1

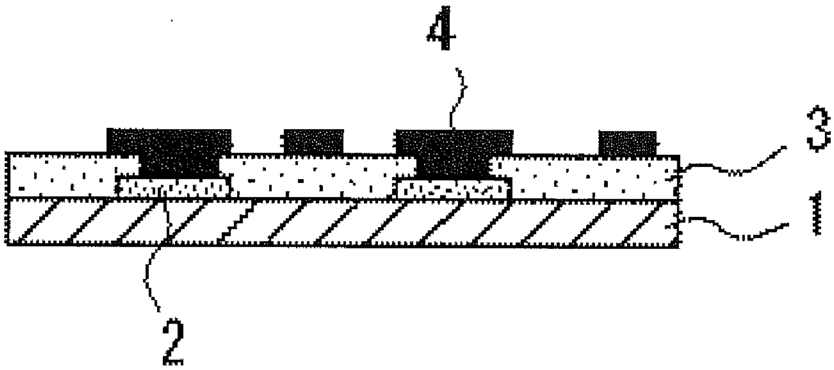


Fig.2

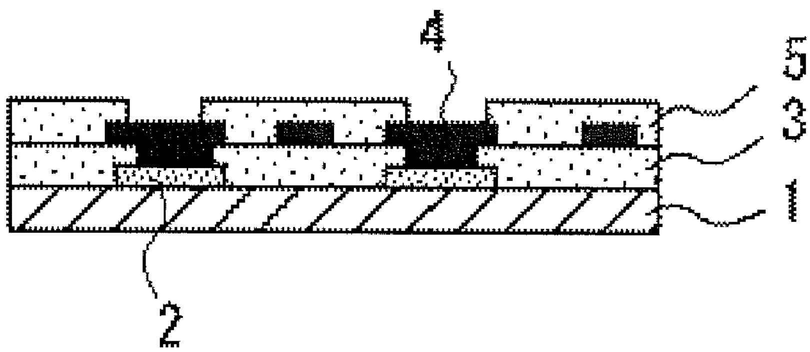

**INTERNATIONAL SEARCH REPORT**

International application No. PCT/JP2011/076958

A. CLASSIFICATION OF SUBJECT MATTER
*C08L71/10*(2006.01)i, *H01L21/312*(2006.01)i

According to International Patent Classification (IPC) or to both national classification and IPC

B. FIELDS SEARCHED

Minimum documentation searched (classification system followed by classification symbols)
C08L71/00-71/14, H01L21/312-21/32, H01L21/47-21/475, H01L21/88-21/90

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 9-202823 A (Air Products and Chemicals Inc.),<br>05 August 1997 (05.08.1997),<br>claims; paragraphs [0001], [0037], [0040] to [0045], [0063], [0064], [0081], [0082], [0096] to [0098]<br>& US 5658994 A & EP 758664 A1<br>& DE 69610674 D & DE 69610674 T<br>& SG 43382 A & IL 118813 A<br>& KR 10-0215325 B & IL 118813 D0 | 1-8,10-15<br>9 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 February, 2012 (17.02.12) | 28 February, 2012 (28.02.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/076958

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 9-202824 A (Air Products and Chemicals Inc.),<br>05 August 1997 (05.08.1997),<br>claims; paragraphs [0001], [0062], [0065] to [0069], [0087], [0088], [0105], [0106], [0120] to [0122]<br>& US 5874516 A & EP 755957 A1<br>& DE 69602318 C & DE 69602318 D<br>& IL 118812 A & SG 67356 A<br>& HK 1011700 A & KR 10-0215326 B<br>& IL 118812 A0 | 1-8,10-15<br>9 |
| X<br>A | JP 5-506042 A (Allied-Signal Inc.),<br>02 September 1993 (02.09.1993),<br>claims; page 3, upper right column, lines 21 to 24; lower right column, lines 7 to 9; page 4, lower left column, lines 9 to 12; lower right column; page 5, upper left column; lower left column, line 6 to page 6, upper left column, line 9; examples 5 to 7, 9 to 11, 14<br>& JP 5-502257 A & JP 3061194 B<br>& JP 3064011 B & JP 3089032 B<br>& JP 5-507742 A & JP 5-506042 A<br>& US 5114780 A & US 5155175 A<br>& US 5179188 A & US 5204416 A<br>& US 5115082 A & EP 504265 A<br>& EP 505438 A & EP 524930 A<br>& EP 525087 A & WO 1991/009071 A1<br>& WO 1991/009081 A1 & WO 1991/016369 A1<br>& WO 1991/016370 A1 & DE 69025410 C<br>& DE 69030197 C & DE 69128280 T<br>& DE 69025410 D & DE 69030197 D<br>& DE 69128280 D & ES 2082963 T<br>& ES 2099155 T & ES 2111565 T<br>& DK 504265 T & AT 134208 T<br>& AT 150043 T & AT 160577 T<br>& CA 2070809 A & CA 2070836 A<br>& CA 2080831 A & CA 2080832 A<br>& GR 3019738 T & CA 2070809 A1 | 1-8,10-15<br>9 |
| X<br>A | JP 2010-73388 A (Toray Industries, Inc.),<br>02 April 2010 (02.04.2010),<br>claims; paragraphs [0022], [0043], [0060], [0104], [0105]; example 7<br>(Family: none) | 1-8,10,11<br>9,12-15 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007246629 A
- JP H0245526 A